# EUROPEAN PATENT APPLICATION

(11) **EP 1 227 588 A1**
(43) Date of publication of application: **31.07.2002**
(21) Application number: 00970104.6
(22) Date of filing: 26.10.2000
(51) Int. Cl.: H03K 17/04, H03K 17/687, H01L 29/78

(54) **UNIPOLAR TRANSISTOR AND POWER CONVERTER COMPRISING IT**

(30) Priority: 27.10.1999 JP 30513899; 18.11.1999 JP 32811399; 26.11.1999 JP 33646899; 26.11.1999 JP 33600999; 07.12.1999 JP 34746999
(71) Applicant: FUJI ELECTRIC CO., LTD., Kawasaki-shi, Kanagawa 210-0856 (JP)
(72) Inventor: KINOSHITA, Shigenori, c/o Fuji Electric Co., Ltd., Kawasaki-shi, Kanagawa 210-0856 (JP); UEKI, Koichi, c/o Fuji Electric Co., Ltd., Kawasaki-shi, Kanagawa 210-0856 (JP)
(74) Representative: DIEHL GLAESER HILTL & PARTNER
(86) International application number: JP0007510
(87) International publication number: WO0131786

(57) **Abstract**

A unipolar transistor, an inverter including a unipolar semiconductor device as a semiconductor device, a DC-DC converter including a unipolar transistor, and a semiconductor switch circuit including a complementary connection of unipolar transistors having a parasitic diode. The unipolar transistor incorporating parasitic diodes in antiparallel connection is characterized in that the rise voltage of the parasitic diode is equal to or higher than an ON voltage appearing when a specified current is fed to the unipolar transistor in an ON state.

## Description

### Technical Field

The present invention relates to the characteristics of a unipolar transistor, to an inverter formed by a semiconductor switch, more specifically to an inverter using a unipolar type semiconductor device, to a circuit configuration of a DC-DC converter, more specifically to a DC-DC converter formed using a unipolar type transistor, or to a semiconductor switch circuit formed through a complementary connection of a unipolar transistor having a parasitic diode.

### Background Art

A transistor can be a unipolar transistor and a bipolar transistor.

FIG. 1 shows a typical ON characteristic of a bipolar device. (a) indicates the ON characteristic of a typical IGBT of a bipolar transistor, and a gate voltage Vg is represented by a parameter. (b) shows the ON characteristic of a diode.

FIG. 2 shows a part of the basic structure of the device section of the IGBT which is a typical bipolar transistor having the ON characteristic shown in FIG. 1. The basic structure is well known.

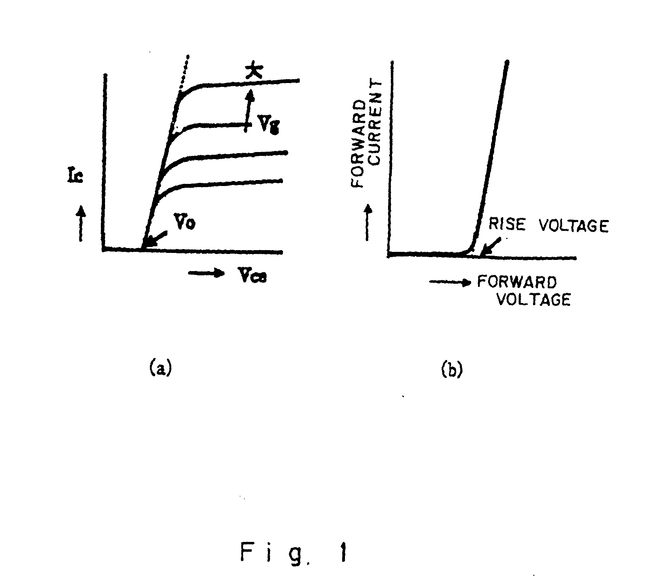

That is, as shown in FIG. 1, the bipolar device indicates the rise voltage Vo specific to the bipolar devices. The rise voltage Vo is about 1V for a diode, about 1 volt for the IGBT having one stage of output transistor, and about 3 volt for three stages with Darlington connection.

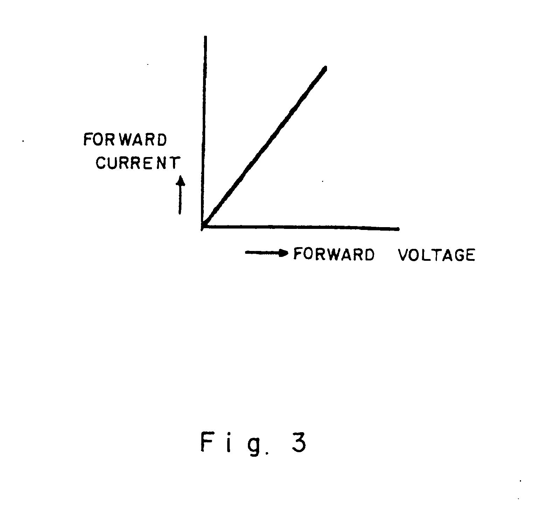

FIG. 3 shows the typical ON characteristic of a unipolar transistor.

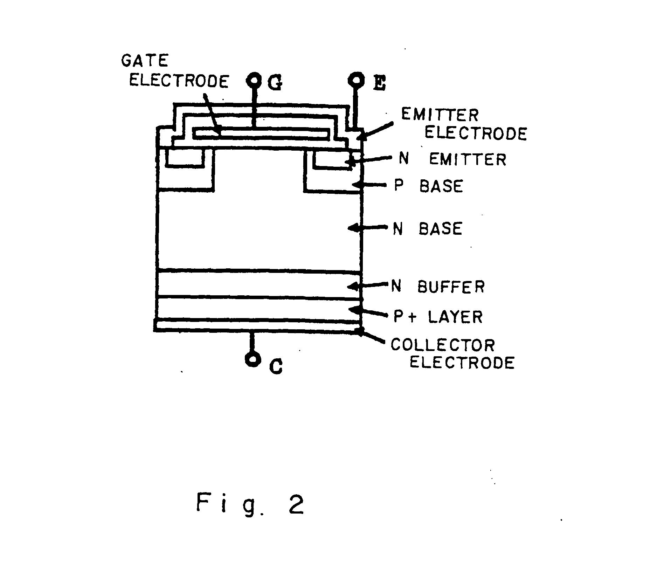

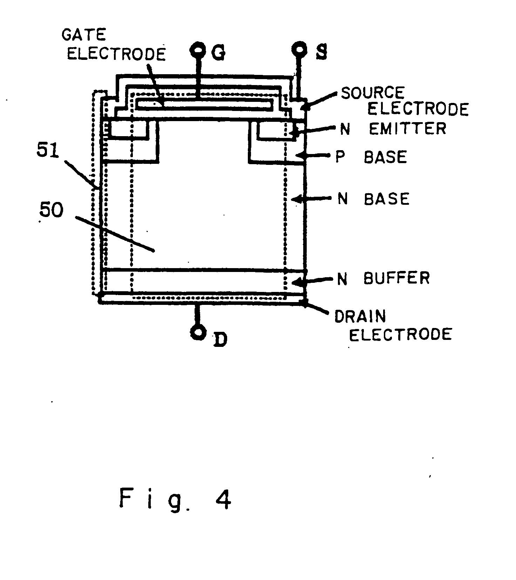

FIG. 4 shows a part of the basic structure of the device section of the MOSFET of the typical unipolar transistor having the ON characteristic shown in FIG. 3 in the form compared to FIG. 2 explained above. The MOSFET shown in FIG. 4 is configured by a built-in parasitic diode 51 with the structure of the FET taken into account. The basic structure is well known.

Described, below is a typical semiconductor power converter.

First described is an inverter which is a DC-AC converter.

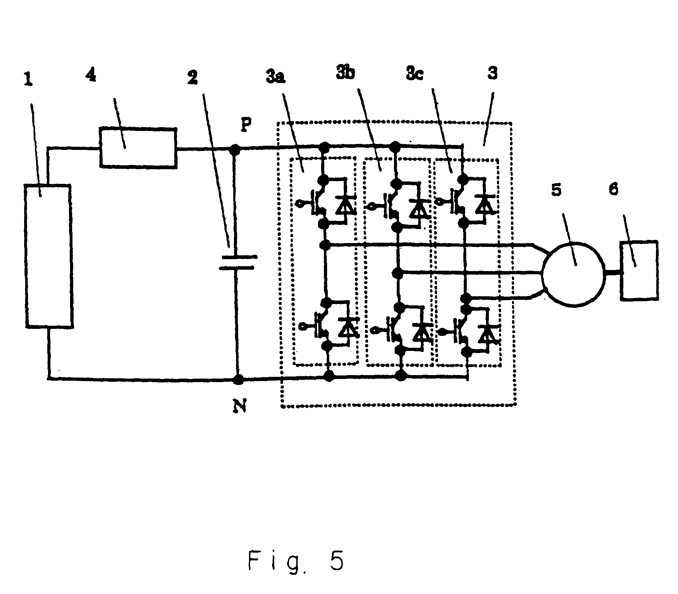

FIG. 5 shows the configuration of the circuit applied to a 3-phase inverter using the IGBT which is a bipolar transistor as an auto-arc-suppression device, and the configuration of the circuit of the 3-phase inverter system using the IGBT which is a bipolar transistor as a semiconductor switch.

In FIG. 5, the circuit includes a DC power 1, a voltage smoothing capacitor 2 connected to the DC side of an inverter 3 formed by upper and lower arms (switch arm) 3a, 3b, and 3c formed by an antiparallel circuit of an IGBT and a diode in a bridge connection configuration as shown in FIG. 5, an initial charge circuit 4 of the voltage smoothing capacitor 2, a motor 5 (motor of a load of the inverter 3) powered on through the inverter 3, and a load 6 of the motor 5. P indicates the positive pole side of a direct current, and N indicates the negative pole side of a direct current. Since the detailed operations of the inverter are well known, the descriptions are omitted here.

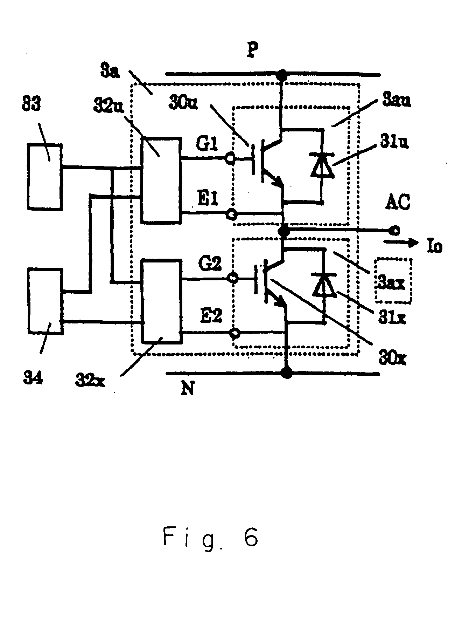

FIG. 6 shows the detailed configuration of the circuit using the upper and lower arms 3a shown in FIG. 5 as an example. Diodes 31u and 31x are connected inversely parallel to the IGBT, an upper arm 3au (a switching circuit on the P side) including an IGBT 30u and the diode 31u, a lower arm (a switching circuit on the N side) 3ax including an IGBT 30x and a diode 31, a gate control circuit 32u of the IGBT 30u, a gate control circuit 32x of the IGBT 30x, a gate driving power 33, and an inverter control circuit 34. The configuration is the same as with the upper and lower arms 3b and 3c. As is well known, the current of the output terminal AC is an alternating current, each IGBT is connected to the diodes 31u and 31x in antiparallel.

Since the detailed operations and control of the inverter is not the gist of the present invention, the detailed explanation is omitted here.

In FIG. 6, since the diodes 31u and 31x are also bipolar devices, they have the voltage-current characteristic of the rise voltage Vo as shown in FIG. 1.

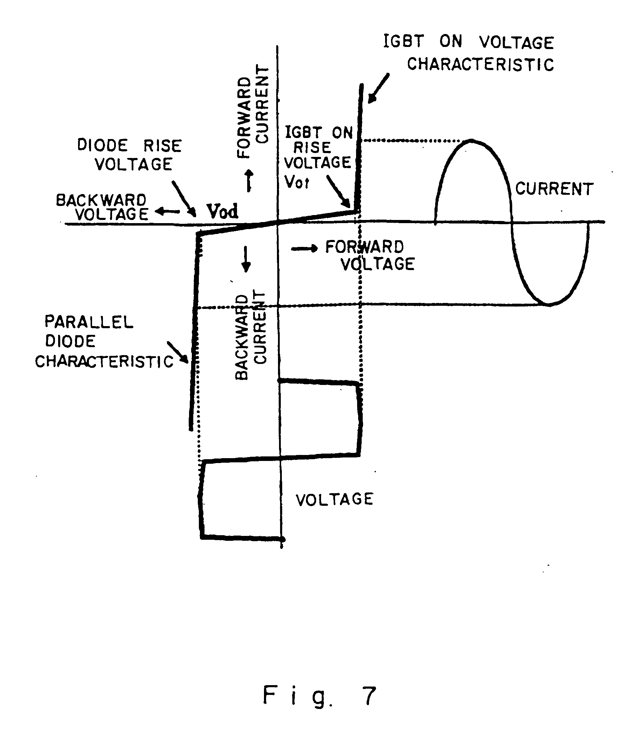

The voltage-current characteristic indicated when a current flows forward and backward of the upper and lower arms 3au and 3ax as shown in FIG. 6 refers to the rise voltage of the bipolar transistor and the diode in a forward current and a backward current as shown in FIG. 7. Vot denotes the rise voltage of the IGBT, and Vod denotes the rise voltage of the antiparallel diode.

In the inverter of this type, the rise voltages of the IGBT and the diode are minimized to reduce the loss when a current flows through each semiconductor device.

FIG. 7 shows the typical ON characteristic of the switch arm 3au shown in FIG. 6.

As shown in FIG. 7, the ON characteristic of the forward current indicates the rise voltage Vot specific to the bipolar transistor. The rise voltage Vot if 1(V) for a one stage output transistor of the IGBT and about 3(V) for a three stage Darlington transistor. The backward current characteristic indicates the ON voltage characteristic of the diode which is a bipolar device. Vod refers to the rise voltage of a diode.

In the semiconductor switch of this type, the rise voltages of the IGBT and the diode are minimized to reduce the loss when a current flows through a semiconductor.

The IGBT (bipolar device) shown in FIGS. 5 and 6 can be replaced with the MOSFET (unipolar device) for an inverter.

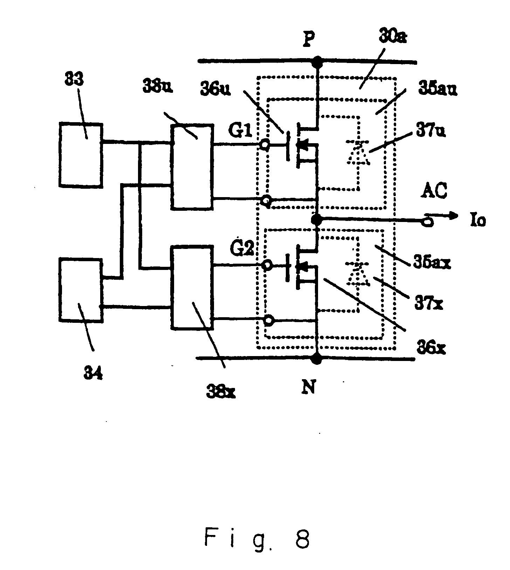

FIG. 8 shows the configuration of the circuit using the MOSFET for an arm. The circuit includes upper and lower arms 30a corresponding to the upper and lower arms 3a shown in FIG. 6, an upper arm 35au corresponding to the upper arm 3au shown in FIG. 6, a lower arm 30ax corresponding to the lower arm 3ax shown in FIG. 6, MOSFETs 36u and 36x, parasitic diode 37u and 37 of the MOSFETs 36u and 36X respectively, and gate driving circuits 38u and 38x of the MOSFETs 36u and 36x respectively.

That is, as shown in FIG. 8, the MOSFET 36u and the MOSFET 36x are auto-arc-suppression devices having the same functions, and the gate driving circuit 38u and the gate driving circuit 38x has the same circuit configurations although the detailed circuit configuration is not shown. Since the MOSFET 36u is different from the MOSFET 36x in gate potential, the driving power and the gate control circuit are provided with electric insulation.

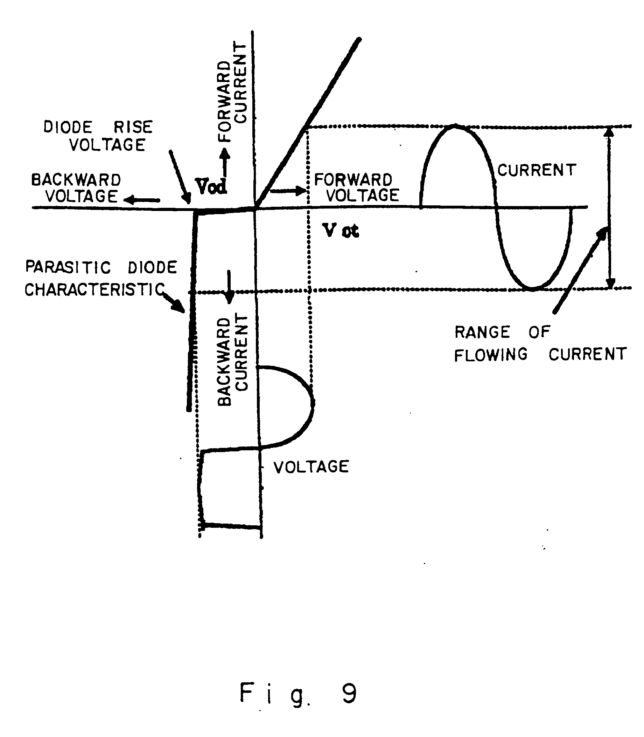

In an inverter with a bridge configuration, the MOSFET and the IGBT are commonly used in the same manner. That is, when a forward current of each arm flows, the gate of the MOSFET is turned on, and when a backward current flows, the current flows through a parasitic diode. FIG. 9 shows the voltage-current characteristic of the MOSFET in this usage in comparison with the characteristic shown in FIG. 7.

That is, FIG. 9 shows the characteristic of the switching circuit shown in FIG. 8 in comparison with FIG. 7. As shown in FIG. 8, the forward voltage-current characteristic is a unipolar characteristic which is a MOSFET characteristic, and the backward voltage-current characteristic is a bipolar characteristic which is a diode characteristic. However, the backward characteristic is a diode characteristic is a diode characteristic as in FIG. 7 because the parasitic diode of the MOSFET has the same characteristic as the diode connected in antiparallel to the IGBT shown in FIG. 6.

A big objects in realizing the semiconductor power converter using a semiconductor device such as an inverter are to improve the conversion efficiency, to improve the performance of the device, to realize a smaller and lighter device at a lower cost.

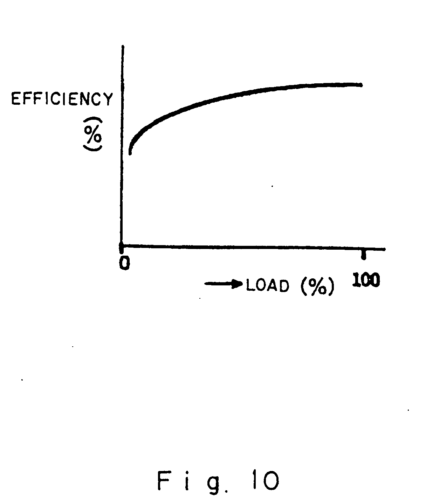

FIG. 10 shows an example of the relationship between the load of the 3-phase inverter using a bipolar transistor and the conversion efficiency. As clearly shown by the relationship, the conversion efficiency drops when the load is smaller. Especially, there is a big object to improve the conversion efficiency when the load of the semiconductor power converter such as an inverter, etc. is small from the viewpoint of saving energy.

Described below is a DC-DC converter, that is, a chopper.

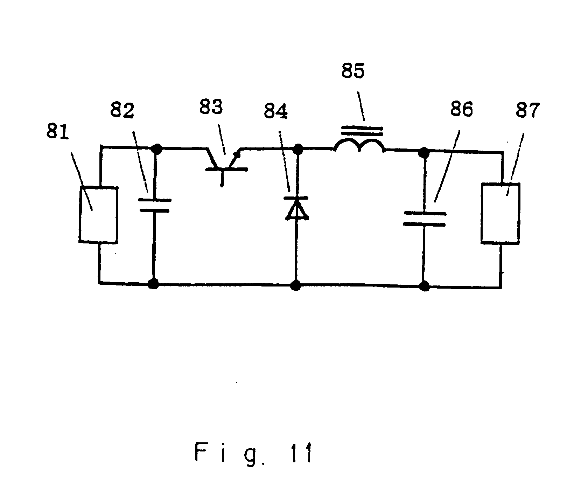

The circuit shown in FIG. 11 is a DC-DC converter widely used as a step-down chopper.

In FIG. 11, the circuit includes a high voltage side DC power 81, a voltage smoothing capacitor 82 on the high voltage side, a semiconductor switch 83, a diode 84, a current smoothing reactor 85, a voltage smoothing capacitor 86 on the low voltage side, and a low voltage side DC power 87. The semiconductor switch shown in FIG. 11 is shown as an IGBT which is a bipolar device.

In FIG. 11, a DC-DC power conversion is performed by switching the semiconductor switch 83 in a high frequency switching operation. The power conversion control is performed by switching the semiconductor switch 83 at a predetermined frequency and controlling the Ton/T ratio. Ton refers to an ON time of the semiconductor switch 83, and T refers to a switching period.

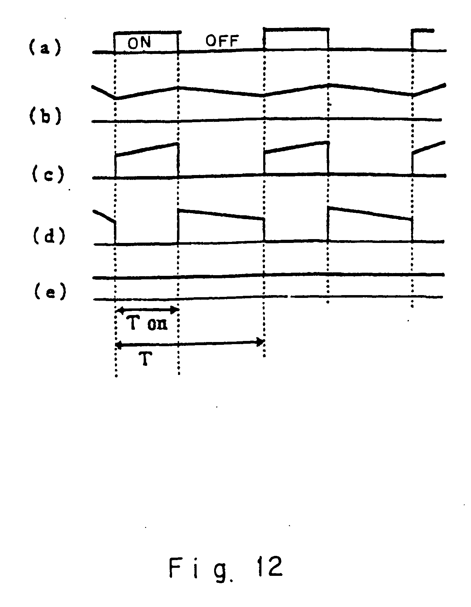

FIG. 12 shows the control of the chopper shown in FIG. 11 and the operation waveform of each unit. In FIG. 12, (a) shows waveform of the gate-on signal of the semiconductor switch 83, (b) shows the waveform of the current of the current smoothing reactor 85, (c) shows the waveform of the current of the semiconductor switch 83, (d) shows the waveform of the current of the diode 84, (e) shows the waveform of the voltage of the voltage smoothing capacitor 86.

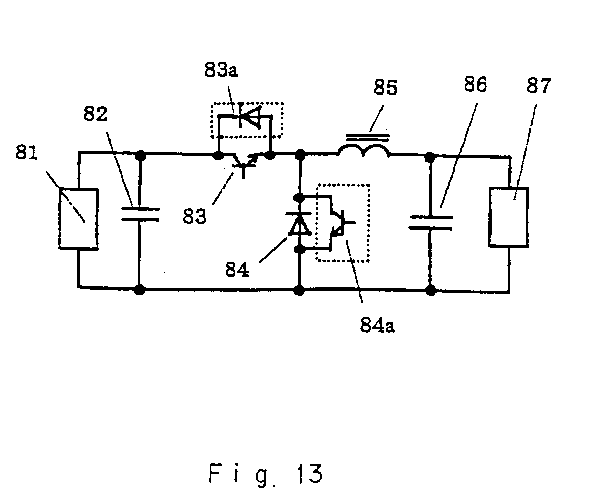

The chopper shown in FIG. 11 which can be a bi-directional power conversion chopper capable of performing power conversion from the low voltage side to the high voltage side as shown in FIG. 13 is also well known. In FIG. 13, a component also shown in FIG. 11 is assigned the same reference numeral.

FIG. 13 shows the circuit shown in FIG. 11 provided with circuit elements 83a and 84a. That is, the diode 83a is connected to the semiconductor switch 83, and the semiconductor switch 84a is connected to the diode 84 as shown in FIG. 13. In FIG. 13, in addition to the step-down chopper operation by the switching of the semiconductor switch 83, the power conversion can be performed from the low voltage side to the high voltage side by switching the semiconductor switch 84a. That is, FIG. 13 shows the chopper system capable of performing the power conversion in the step-down and step-up methods.

The operation of the step-down chopper is the same as in the case shown in FIG. 12, but in the step-up chopper operation, the semiconductor switch 84a is switched in a predetermined period by controlling the Ton/T ratio. Ton refers to the ON time of the semiconductor switch 84a, and T refers to the switching period.

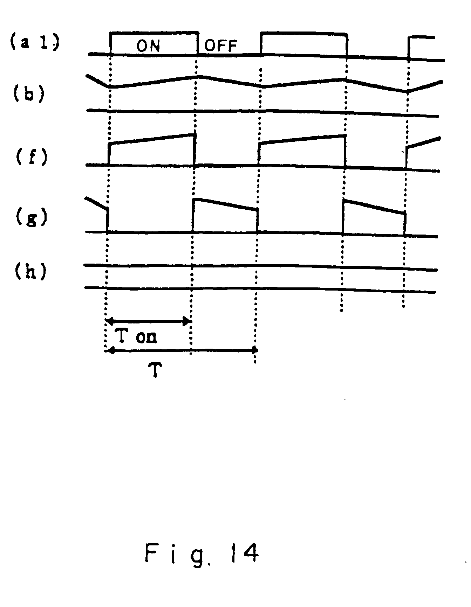

FIG. 14 shows the waveform of each unit of the step-up chopper operation in comparison with FIG. 12.

In FIG. 14, (a1) shows the waveform of the gate-on signal of the semiconductor switch 84a, (b) shows the waveform of the current of the current smoothing reactor 85, (f) shows the waveform of the current of the semiconductor switch 84a, (g) shows the waveform of the current of the diode 83a, and (h) shows the waveform of the voltage of the voltage smoothing capacitor 82.

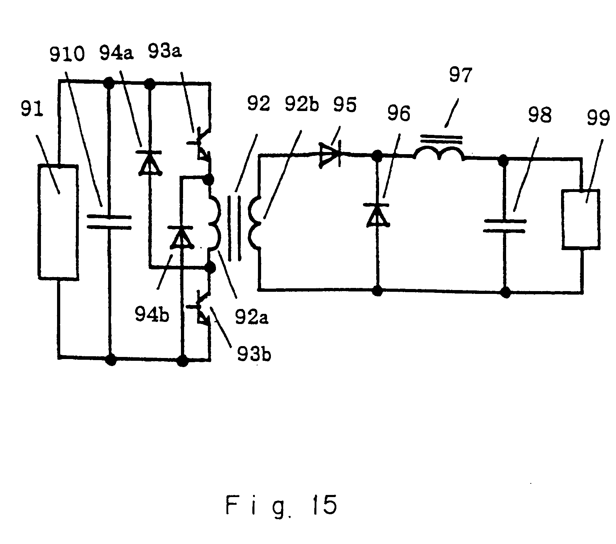

FIG. 15 shows the configuration of the circuit of the insulating one-way operation DC-DC converter as a DC-DC converter of this type, and the DC-DC converter is widely used for use in, for example, charging the direct current power from several 100 V to several 10 V, etc.

In FIG. 15, the circuit includes a high voltage side direct current power 91, a transformer 92 having a primary coil 92a and a secondary coil 92b, semiconductor switches 93a and 94a, return currents 94a and 94b for returning an exciting current of the transformer 92, rectification diodes 95 and 96, a current smoothing reactor 97, a smoothing capacitor 98, a low voltage side direct current power 99, and a smoothing capacity 910. The semiconductor switches 93a and 93b are, in this example. the IGBT which is a bipolar device. Furthermore, the DC-DC converter can also be referred to as a step-down DC-DC converter.

In the DC-DC converter shown in FIG. 15, an AC voltage is generated on the part of the primary coil 92a of the transformer 92 by switching the semiconductor switches 93a and 93b for high frequency, and the power conversion is performed on the AC voltage induced on the part of the secondary coil 92b of the transformer 92 into the DC voltage by the rectification diodes 95 and 96. The power conversion control is performed by switching the semiconductor switches 93a and 93b at a predetermined frequency to control the Ton/T ratio. Ton refers to the ON time of the semiconductor switches 93a and 93b, and T refers to the above mentioned switching period.

With the configuration of the circuit shown in FIG. 15, in one period of the above mentioned switching period, a voltage is applied to the transformer 92 for about a half cycle, and the magnetic flux of the iron core of the transformer 92 is reset in the remaining half cycle.

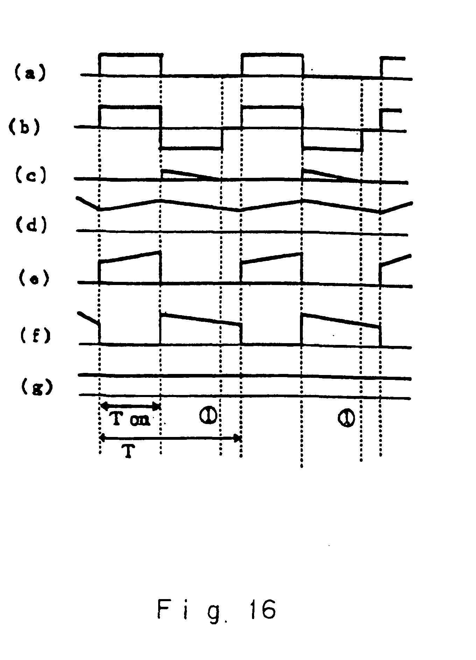

FIG. 16 shows the power conversion of the DC-DC converter shown in FIG. 15 and the operation waveform of each unit, and (a) shows the waveform of the gate-on signal of the semiconductor switches 93a and 93b, (b) shows the waveform of the secondary coil voltage of the transformer 92, (c) shows the waveform of the current of the return current diodes 94a and 94b, (d) shows the waveform of the current of the current smoothing reactor 97, (e) shows the waveform of the current of the rectification diode 95, (f) shows the waveform of the current of the rectification diode 96, (g) shows the waveform of the voltage of the smoothing capacitor 98.

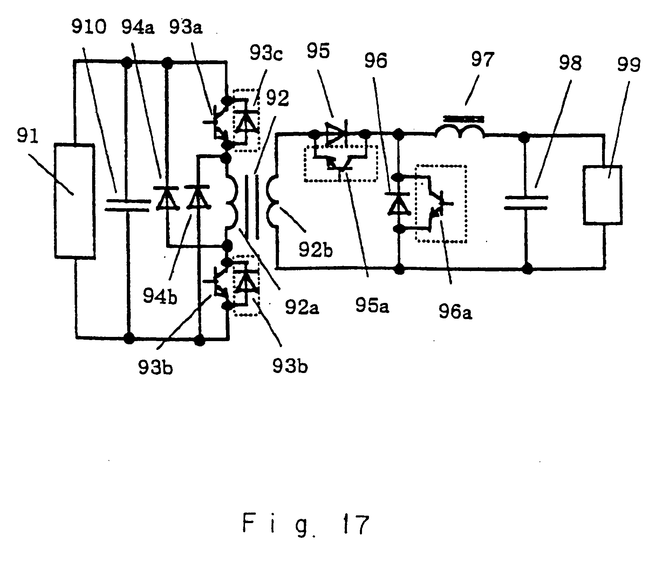

FIG. 17 shows the configuration of the circuit of the DC-DC converter indicating another conventional example in addition to the DC-DC converter shown in FIG. 15, and the configuration of the circuit corresponds to an insulating bi-directional operation DC-DC converter capable of performing power conversion from the low voltage side to the high voltage side. A component also shown in FIG. 15 is assigned the same reference numeral.

In FIG. 17, the circuit element of the portion encircled by a dotted line is added to the circuit configuration shown in FIG. 15. That is, a diode 93c is connected to the semiconductor switch 93a, a diode 93d is connected to the semiconductor switch 93b, a semiconductor switch 95a is connected to the rectification diode 95, and a semiconductor switch 96a is connected to the rectification diode 96 through the polarity as shown in FIG. 17.

The DC-DC converter shown in FIG. 17 can perform the operations of the step-down DC-DC converter through the switching operations of the semiconductor switches 93a and 93b, and can perform the power conversion from the low voltage side direct current power 99 to the high voltage side direct current power 91 through the switching operations of semiconductor switches 95a and 96a. That is, the DC-DC converter can perform the bi-directional power conversion of the step-down and step-up operations. In the power conversion of the step-up operation, the semiconductor switch 96a switches in a predetermined period, and controls the Ton/T ratio. Ton refers to the ON time of the semiconductor switch 96a, and T refers to the above mentioned switching period.

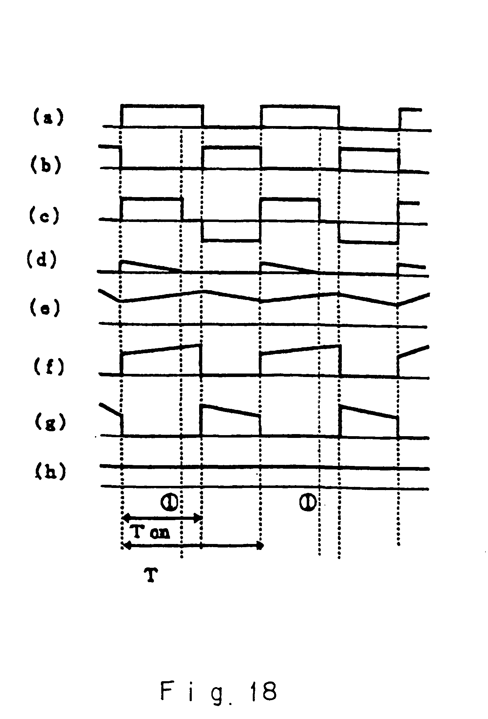

FIG. 18 shows the waveform of each unit of the power conversion of the step-up operation in the DC-DC converter shown in FIG. 17 in comparison with FIG. 16.

That is, in FIG. 18, (a) shows the gate-on signal of the semiconductor switch 96a, (b) shows the gate-on signal of the semiconductor switch 95a, (c) shows the voltage of the secondary coil of the transformer 92, (d) shows the current of the return current diodes 94a and 94b, (e) shows the current of the current smoothing reactor 97, (f) shows the current of the semiconductor switch 96a, (g) shows the current of the semiconductor switch 95a, and (h) shows the waveform of the voltage of the smoothing capacity 910. In the waveform chart shown in FIG. 18, the semiconductor switch 95a performs a synchronous rectifying operation. That is, when the semiconductor switch 96a is turned OFF, the semiconductor switch 95a is turned on. When the semiconductor switch 96a is turned ON, the semiconductor switch 95a is turned OFF.

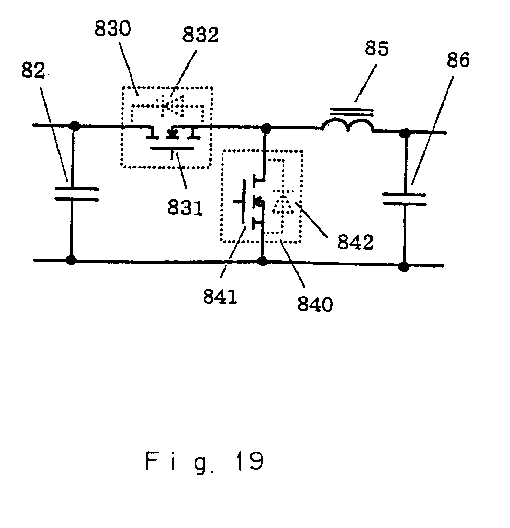

To realize a smaller and lighter device in the circuit shown in FIG. 13, a circuit system in which the IGBT is switched into the MOSFET as a switch device as shown in FIG. 19 has been suggested. The feature of the circuit resides in that the parasitic diode originally built in the MOSFET is actively used as a diode in antiparallel to the switch device to reduce the number of devices.

In FIG. 19, a component also shown in FIG. 13 is assigned the same reference numeral. The circuit includes MOSFET switches 830 and 840, MOSFET transistors 831 and 841, and parasitic diodes 832 and 842 of the MOSFET. The operations shown in FIG. 19 are the same as the operations shown in FIG. 13, and the explanation is omitted here.

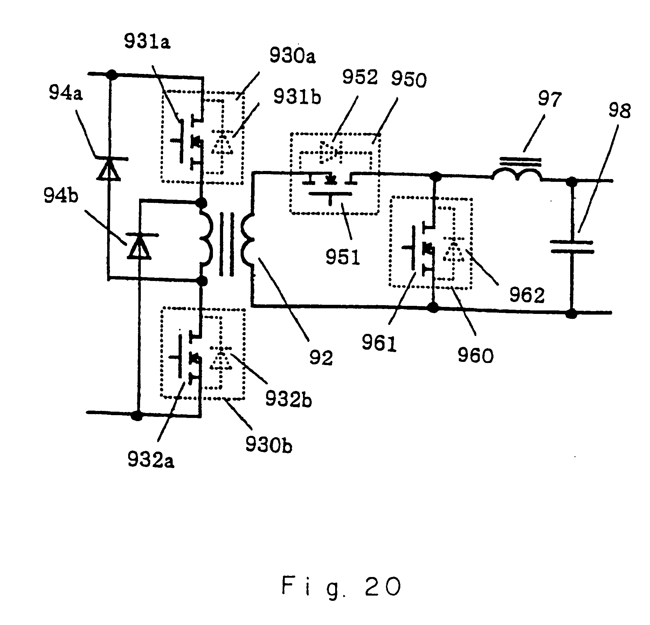

In the DC-DC converter shown in FIG. 17, to realize a smaller and lighter device, a DC-DC converter in which the IGBT is switched into the MOSFET as the above mentioned semiconductor switch has been suggested as with the circuit configuration of the DC-DC converter shown in FIG. 20. The feature of the DC-DC converter resides in that the parasitic diode originally provided for the MOSFET is actively used to reduce the number of parts.

In the DC-DC converter shown in FIG. 20, a component also shown in the circuit configuration shown in FIG. 17 is assigned the same reference numeral, and the circuit includes MOSFETs 930a, 930b, 950, and 960, MOSFET units 931a, 931b, 951, and 961, and parasitic diodes 931b, 932b, 952, and 962. The operations of the DC-DC converter are the same as the operations of the DC-DC converter shown in FIG. 17.

To improve the conversion efficiency when a smaller load is applied to the above mentioned inverter and DC-DC converter can be effectively described below in 1) and 2).
1) A bi-directional unipolar characteristic is applied.
2) Switching performance is enhanced to practically ignore a switching loss.

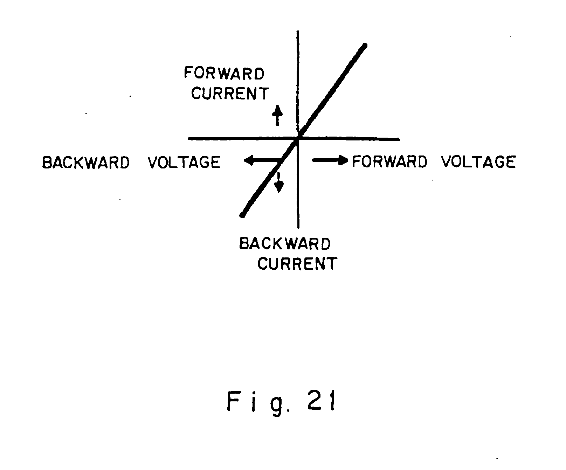

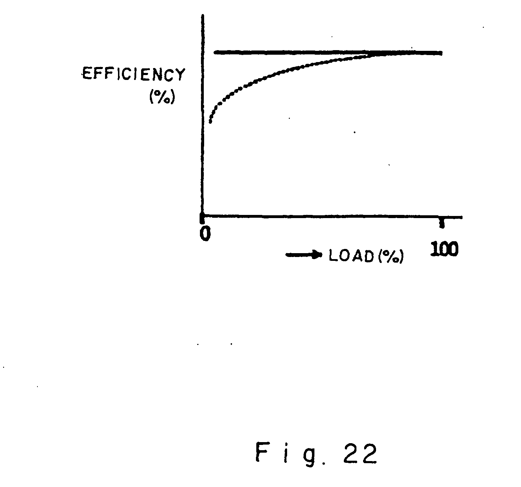

FIG. 21 shows the voltage-current characteristic when an ideal device satisfying 1) and 2) above is used. The device having the characteristic shown in FIG. 21 is a bi-directional unipolar type device. FIG. 22 shows the device having the conversion efficiency characteristic with zero switching loss in comparison with FIG. 10. The solid line indicates the characteristic of the device shown in FIG. 21, and the dotted line indicates the characteristic shown in FIG. 10.

A MOSFET is a device expected to improve the conversion efficiency. As described above, the device is unipolar, but the characteristic in the backward current refers to a bipolar device of a parasitic diode. At present, a unipolar semiconductor device has not been realized in forward and backward currents, and is expected to be realized the sooner. Furthermore, since the present MOSFET is unipolar, the operation switching frequency is about 10 times as high as a bipolar. However, a parasitic diode is bipolar, and the switching frequency of the parasitic diode is as high as the IGBT, that is, about 1/10 of the MOSFET. There also is an object to operate the parasitic diode of the MOSFET at a higher speed.

When a bipolar transistor is used as a switching device of an inverter, another problem that a switching frequency cannot be enhanced occurs because of the accumulation carrier specific to the bipolar device in a bipolar transistor.

A parasitic diode has a carrier accumulated in the device when it is turned on, and the device cannot enter the OFF state until the accumulated carrier can be removed during the OFF state. This phenomenon is referred to as a carrier accumulation effect, and the period until the accumulated carrier can be removed is referred to as a carrier accumulation time or a storage time.

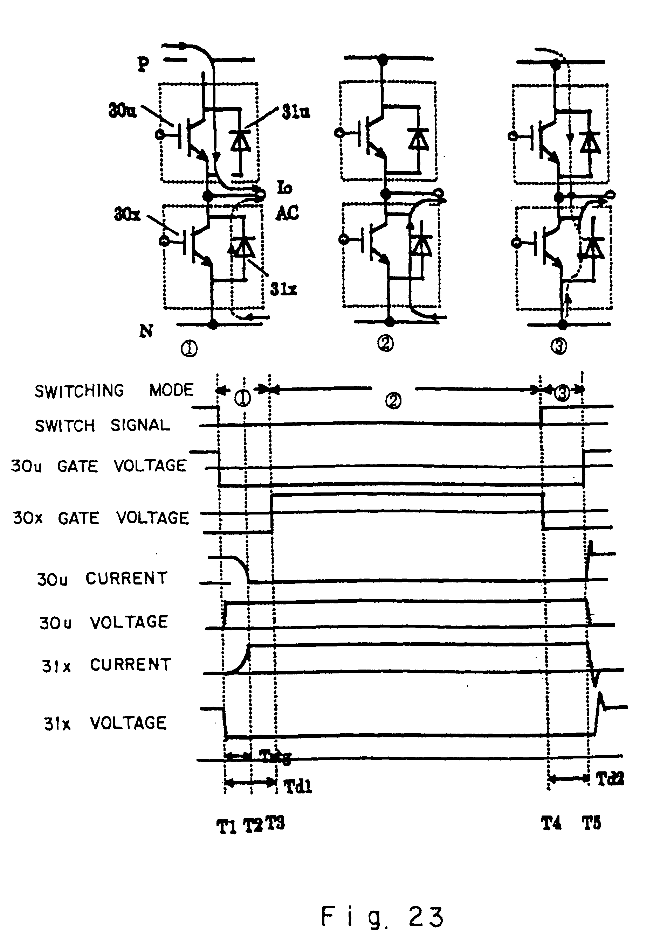

FIG. 23 shows the relationship between the phenomenon and the switching operation of the inverter. Described below is the operation shown in FIG. 23. The switching mode 1 is a mode in which the IGBT (30u) is turned off to allow the load current Io to be transferred from the IGBT (30u) to the diode (31x). The switching mode 2 is a mode in which the load current Io continuously flows through the diode (31x). The switching mode 3 is a mode in which the IGBT (30u) is turned on to allow the load current Io to be transferred from the diode (31x) to the IGBT (30u).

In FIG. 23, although the gate of the IGBT (30u) is turned off at a time T1, the IGBT is not immediately turned off, but a current flows for a time. In FIG. 23, the time is represented by Tstg (accumulated carrier time). If the IGBT (30u) is turned off at the time T1 and simultaneously the IGBT (30x) is turned on, then the arm is short-circuited (between the PN in FIG. 23). Therefore, the IGBT inverter is provided with a dead time such that the IGBT (30x) cannot be turned on for a predetermined time after the IGBT (30u) is turned off. In FIG. 23, the dead time is represented by Td. At present, the dead time is about 1 µs in a commonly used IGBT inverter.

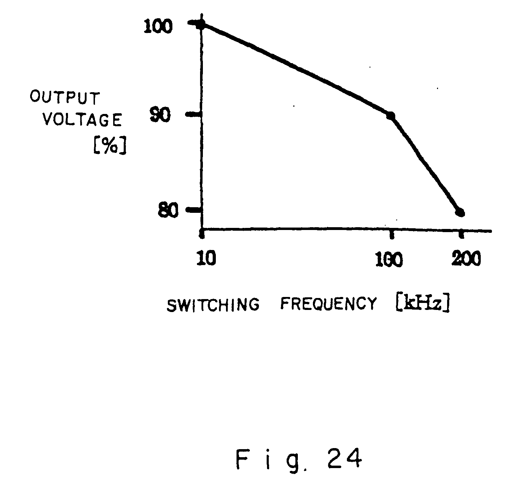

The dead time largely affects the upper limit of the switching frequency of the inverter. FIG. 24 shows the relationship between the switching frequency by the dead time and the output voltage of the inverter. In FIG. 24, the dead time is 1 µs. When the switching frequency becomes higher, the output voltage by the dead time decreases as shown in FIG. 24. Therefore, in the present inverter using the IGBT, the switching frequency is about 10 kHz or lower.

Furthermore, the problem with the dead time is the distortion in waveform of the output voltage of an inverter. Especially, there is a limit in performance of a high-performance inverter due to the distortion of the waveform of an output voltage, there by requiring the improvement of waveform distortion for the high-performance inverter of this type.

Described below is the case in which the MOSFET (unipolar device) shown in FIG. 8 is used in the inverter. The MOSFET used at present is designed such that the parasitic diode in the MOSFET can have a lower ON voltage as indicated by the characteristic shown in FIG. 9. From the characteristic of the parasitic diode, there is the problem with the inverter using the present MOSFET that the switching frequency cannot be enhanced. The problem is described below in detail.

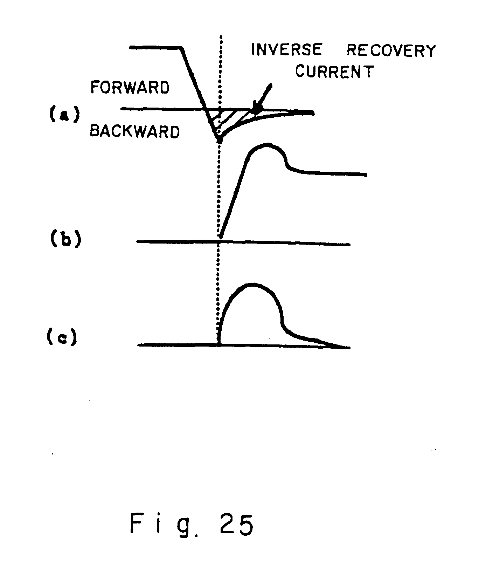

The operation frequency of a diode is limited by the inverse recovery characteristic of a diode. FIG. 25 shows the operation (corresponding to the operation at time T5 in FIG. 23) when the parasitic diode is turned off. In FIG. 25, (a) shows the waveform of the current of a parasitic diode, (b) shows the of the voltage of a parasitic diode, and (c) shows the waveform of a loss generated in the parasitic diode when power is turned off. In the waveform of (a), the current of the shadowed portion is an inverse recovery current when the parasitic diode is turned off. The waveform loss generated when the parasitic diode is turned off is obtained as a product of the current in (a) and the voltage in (b). The switching loss of the parasitic diode is obtained by multiplying the lost waveform integral value by switching frequency. The parasitic diode of the present MOSFET is designed such that the rise voltage can be lowest possible to minimize the loss of an inverter. Therefore, the switching loss of the parasitic diode is large, and about several 10 kHz is the frequency limit.

Thus, although the switch device using the present MOSFET is unipolar in the forward direction and the switching frequency is about several 100 kHz, the backward current characteristic is a bipolar characteristic, and the inverse recovery characteristic induces the switching frequency of about 1/10 of the MOSFET.

Therefore, it has been expected to realize an inverter using a highly efficient MOSFET.

However, at present
(1) no bi-directional unipolar device is not realized, and
(2) the possible operation switching frequency of the parasitic diode in the MOSFET is about 1/10 of the MOSFET, and since the MOSFET cannot enhance the switching frequency,
(3) it has been expected to realize a smaller, lighter, and more efficient semiconductor power converter.

To attain the required objects, it is necessary to enhance the switch, and minimize the switching loss.

The present invention has been developed to solve the above mentioned problems, and aims at providing a smaller and highly efficient semiconductor switch circuit with a high switching frequency in the bi-directional current.

### Disclosure of Invention

The first aspect of the present invention is characterized by a unipolar transistor including a parasitic diode in the opposite parallel in direction to the unipolar transistor, and in that the rise voltage of the parasitic diode is set equal to or higher than the ON voltage appearing when a predetermined current flows with the unipolar transistor set in the ON state.

The second aspect of the present invention is characterized in that, in the unipolar transistor according to the first aspect of the present invention, the operable switching frequency of the parasitic diode is set almost the same as the switching frequency of the unipolar transistor.

The third aspect of the present invention is characterized by the unipolar transistor according to the first or second aspect of the present invention in that the unipolar transistor is a MOSFET.

The fourth aspect of the present invention is characterized by the unipolar transistor according to any of the first through third aspects of the present invention in that the predetermined current of the unipolar transistor is set to the maximum absolute rating of the transistor.

These first through fourth aspects of the present invention have been developed based on (1) and (2) below.

(1) The device structure of the MOSFET is bi-directional for a unipolar device.

(2) The parasitic diode is a bipolar device. When the diode is operated at a high speed, the rise voltage increases.

That is, the rise voltage of the parasitic diode is set equal to or higher than the ON voltage of the specified current of the MOSFET, the switching frequency of the diode is set almost the same as the switching frequency of the MOSFET, and the MOSFET is operated in the area of the bi-directional current as described in (1) above.

The fifth aspect of the present invention is characterized by an inverter in which a unipolar transistor, having the rise voltage of the parasitic diode included in antiparallel to the unipolar transistor set equal to or higher than the ON voltage appearing when a specified current flows in the ON state of the unipolar transistor, is configured as a primary switching device. The sixth aspect of the present invention is characterized by the inverter according to the fifth aspect of the present invention in that the unipolar transistor is a MOSFET.

The seventh aspect of the present invention is characterized by the inverter according to the fifth or sixth aspect of the present invention in that the specified current is the maximum inverter output current.

The eighth aspect of the present invention is characterized by the inverter according to the fifth or sixth aspect of the present invention in that the specified current is the absolute maximum rating of a MOSFET.

These fifth through eighth aspects according to the present invention are realized based on the following conditions.

(3) The device structure of the MOSFET is a bidirectional current unipolar;

(4) When a diode of block diagram type is operated at a high speed, a rise voltage increases;

(5) The carrier accumulation time of the unipolar device is shorter than that of the bipolar device.

The rise voltage of the parasitic diode is set equal to or higher than the ON voltage in the predetermined current of the MOSFET, and the switching frequency of the MOSFET is set almost the same as that of the switching frequency of the MOSFET.

The ninth aspect of the present invention is characterized by a DC-DC converter in which one terminal of a first semiconductor switch is connected to one terminal of a first direct current power, one terminal of a second semiconductor switch and one terminal of a current smoothing reactor are connected to another terminal of the first semiconductor switch, one terminal of a second direct current power is connected to another terminal of the current smoothing reactor, and another terminal of the first direct current power, another terminal of the second semiconductor switch, and another terminal of the second direct current power are connected to each other. With the configuration, the first and second semiconductor switches are unipolar transistors each having a parasitic diode, and the rise voltage of the parasitic diode is set equal to or higher than the ON voltage appearing when a specified current flows through the unipolar transistor.

The tenth aspect of the present invention is characterized by the DC-DC converter according to the ninth aspect of the present invention in that the parasitic diode is assigned a high frequency so that the parasitic diode can be operated at an operation switching frequency of each unipolar transistor.

The eleventh aspect of the present invention is characterized by the DC-DC converter according to the ninth and tenth aspects of the present invention in that the unipolar transistor is used as a MOSFET.

The twelfth aspect of the present invention is characterized by the DC-DC converter according to any of the ninth through eleventh aspects of the present invention in that the current of each of the first and second semiconductor switches is allowed to flow through the unipolar transistor.

The thirteenth aspect of the present invention is characterized by the DC-DC converter according to any of the ninth through twelfth aspects of the present invention in that the switching operations of the first and second semiconductor switches allow power conversion to be performed in both directions between the first direct current power and the second direct current power.

The fourteenth aspect of the present invention is characterized by the DC-DC converter according to any of the ninth through thirteenth aspects of the present invention in that the current smoothing reactor is formed by a serial circuit of a DC reactor and a saturable reactor, and the current discontinuation of the current reactor can be detected by the voltage appearing in the saturable reactor when the current of the current smoothing reactor is inverted.

The fifteenth aspect of the present invention is characterized by the DC-DC converter according to any of the ninth through fourteenth aspects of the present invention in that the current smoothing reactor is formed by a serial circuit of the primary coil of a DC reactor and a saturable reactor, and the current discontinuation of the current smoothing reactor can be detected by the voltage appearing in the secondary coil of the saturable reactor when the current of the current smoothing reactor is inverted.

The ninth through fifteenth aspects have been developed based on the following.

(6) The current of the MOSFET can flow forward and backward during the gate-on process; and

(7) when the bipolar device is operated at a higher speed and frequency, the rise voltage becomes higher based on that:

(8) the parasitic diode of the MOSFET is operable at almost the same switching frequency as the MOSFET; and

(9) the rise voltage of the parasitic diode is set high, and the forward and backward bi-directional current unipolar type ON characteristic is set for the MOSFET as a switching device, and the synchronous rectification is performed by the unipolar transistor so that the bi-directionally operating high efficient and frequency chopper can be realized.

The sixteenth aspect of the present invention is characterized by a DC-DC converter in which a first serial circuit formed by serially connecting a first direct current power with a first semiconductor switch and a first diode is connected parallel to a second serial circuit formed by serially connecting a second diode with a second semiconductor switch, both terminals of a primary coil of a transformer are connected between the intermediate connection point of the first serial circuit and the intermediate connection point of the second serial circuit, one terminal of a third semiconductor switch is connected to one terminal of a secondary coil of the transformer, one terminal of a fourth semiconductor switch and one terminal of a current smoothing reactor are connected to another terminal of the third semiconductor switch, one terminal of a second direct current power is connected to another terminal of the current smoothing reactor, and another terminal of the secondary coil of the transformer, another terminal of the fourth semiconductor switch, and another terminal of the second direct current power are connected to one another. With the configuration, each of the first through the fourth semiconductor switches is a unipolar transistor having a parasitic diode, the rise voltage of each parasitic diode is set equal to or higher than the ON voltage appearing when a specified current flows through each unipolar transistor.

The seventeenth aspect of the present invention is characterized by the DC-DC converter according to the sixteenth aspect of the present invention in that each parasitic diode is operated at a higher frequency so that it can be operated at an operation switching frequency of each unipolar transistor.

The eighteenth aspect of the present invention is characterized by the DC-DC converter according to the sixteenth and seventeenth aspects of the present invention in that the unipolar transistor is a MOSFET.

The nineteenth aspect of the present invention is characterized by the DC-DC converter according to the sixteenth through eighteenth aspect of the present invention in that the current of each of the first through fourth semiconductor switches flows through the unipolar transistor.

The twentieth aspect of the present invention is characterized by the DC-DC converter according to the sixteenth through nineteenth aspects of the present invention in that bi-directional power conversion is performed between the first direct current power and second direct current power by the switching operations of the first through fourth semiconductor switches.

The twenty-first aspect of the present invention is characterized by the DC-DC converter according to the sixteenth through twentieth aspects of the present invention in that the current smoothing reactor is formed by a serial circuit of a DC reactor and a saturable reactor, and the current discontinuation of the current smoothing reactor can be detected by the voltage appearing in the saturable reactor when the current of the current smoothing reactor is inverted.

The twenty-second aspect of the present invention is characterized by the DC-DC converter according to the sixteenth through twentieth aspects of the present invention in that the current smoothing reactor is formed by a serially connected circuit of the primary coils of a DC reactor and a saturable reactor, and the current discontinuation of the current smoothing reactor can be detected by the voltage appearing in the secondary coil of the saturable reactor when the current of the current smoothing reactor is inverted.

The DC-DC converter according to the sixteenth through twenty-second aspect of the present invention is characterized by the following.

(10) At the gate-on of the MOSFET, the current can flow forward and backward.

(11) The parasitic diode as a bipolar device has been developed by a rise voltage enhanced a higher speed and a higher frequency enhance based on that:

(12) The parasitic diode of the MOSFET is operated at the same switching frequency as the MOSFET; and

(13) The MOSFET of the bi-directional current unipolar type ON characteristic is applied as a semiconductor switch with a higher rise voltage of the parasitic diode, and a rectification circuit of the DC-DC converter performs synchronous rectification using a unipolar transistor, thereby realizing a DC-DC converter of a bi-directional, high-efficiency, and high-frequency operation.

The twenty-third aspect of the present invention is characterized by a semiconductor switch circuit formed by a complementary connection of a unipolar transistor having a parasitic diode in that the rise voltage of each parasitic diode is set equal to or higher than an ON voltage appearing when a specified current flows in the ON state of the unipolar transistor.

The twenty-fourth aspect of the present invention is characterized by the semiconductor switch circuit according to the twenty-third aspect of the present invention in that one of the unipolar transistors is an N channel MOSFET, and the other is a P channel MOSFET.

The twenty-fifth aspect of the present invention is characterized by the semiconductor switch circuit according to the twenty-third or twenty-fourth in that the specified current is the maximum current through the semiconductor switch circuit.

The twenty-sixth aspect of the present invention is characterized by the semiconductor switch circuit according to the twenty-fourth aspect of the present invention in that the specified current is the maximum absolute rating of the MOSFET.

The twenty-seventh aspect of the present invention is characterized by the semiconductor switch circuit according to the twenty-third through twenty-sixth aspects of the present invention in that the semiconductor switch circuit is formed by the upper and lower arms of the inverter device with the bridge connection configuration.

The twenty-eighth aspect of the present invention is characterized by the semiconductor switch circuit according to the twenty-third through twenty-sixth aspects of the present invention in that the semiconductor switch circuit is the switch arm of the chopper device.

The twenty-ninth aspect of the present invention is characterized by the semiconductor switch circuit according to the twenty-third through twenty-sixth aspects of the present invention in that the semiconductor switch circuit is formed by the upper and lower arms of the rectifier with the bridge connection configuration.

The twenty-third through twenty-ninth aspects of the present invention have been developed based on the following items (14) through (16).

(14) In the structure of a device, the MOSFET is a bi-directional current unipolar device.

(15) When the diode of the bipolar device is operated at a higher speed, the rise voltage is enhanced.

(16) In a complementary connection, a gate drive circuit, etc. can be shared.

That is, the rise voltage of the parasitic diode of the MOSFET is set equal to or higher than the ON voltage of a specified current of the MOSFET, the switching frequency of the parasitic diode is set almost the same as the switching frequency of the MOSFET, and the semiconductor switch circuit is formed by a complementary connection, thereby improving the conversion efficiency of the semiconductor power converter in smaller size.

### Brief Description of Drawings

FIG. 1 shows the characteristic of an IGBT.
FIG. 2 shows the sectional structure of a device of the typical IGBT.
FIG. 3 shows the characteristic of the MOSFET.
FIG. 4 shows the sectional structure of the conventional MOSFET.
FIG. 5 shows the configuration of the circuit of the three-phase inverter device as a conventional technology, and the circuit system of the inverter using a typical IGBT.
FIG. 6 shows the detailed configuration of the circuit shown in FIG. 5, the configuration of the circuit of an inverter using an IGBT, or an example of the configuration of the switch circuit using an IGBT.
FIG. 7 shows the waveform for explanation of the characteristic (operation) of the switch circuit shown in FIG. 6.
FIG. 8 shows the circuit configuration having a MOSFET as a semiconductor switch in the circuit shown in FIG. 6.
FIG. 9 is an explanatory view of the characteristic shown in FIG. 8.
FIG. 10 shows the conversion efficiency characteristic of an inverter to which an IGBT is applied, and is an explanatory view of the characteristics shown in FIG. 5 or 6.
FIG. 11 shows the configuration of the circuit of the conventional step-down chopper.
FIG. 12 is an explanatory view of the operation shown in FIG. 11.
FIG. 13 shows the circuit configuration of the conventional step-up/step-down chopper.
FIG. 14 is an explanatory view of the operation shown in FIG. 13.
FIG. 15 shows the circuit configuration of a conventional DC-DC converter.
FIG. 16 shows the waveform for explanation of the operation shown in FIG. 15.
FIG. 17 shows the circuit configuration of another conventional DC-DC converter other than the converter shown in FIG. 15.
FIG. 18 shows the waveform for explanation of the operation shown in FIG. 17.
FIG. 19 shows another circuit configuration of a conventional step-up/step-down chopper.
FIG. 20 shows the circuit configuration of another conventional DC-DC converter other than the converters shown in FIGS. 15 and 17.
FIG. 21 shows the characteristic of an ideal unipolar device.
FIG. 22 shows the conversion efficiency characteristic of the device having the characteristic shown in FIG. 21, and shows the loss characteristic of a power converter (semiconductor).
FIG. 23 is an explanatory view of the characteristic shown in FIG. 6.
FIG. 24 is an explanatory view of another characteristic shown in FIG. 5 or 6.
FIG. 25 is an explanatory view of another characteristic shown in FIG. 8.

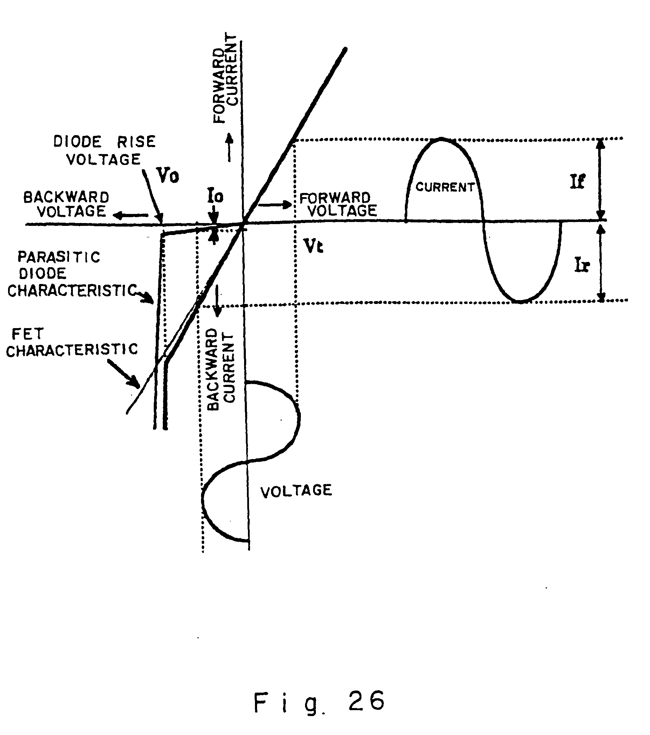

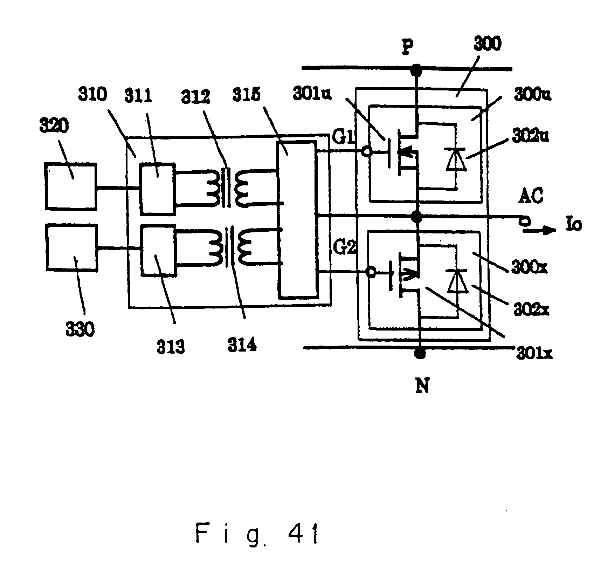

FIG. 26 shows the characteristic according to an embodiment of the present invention, and shows the characteristic of the operation shown in FIG. 41.

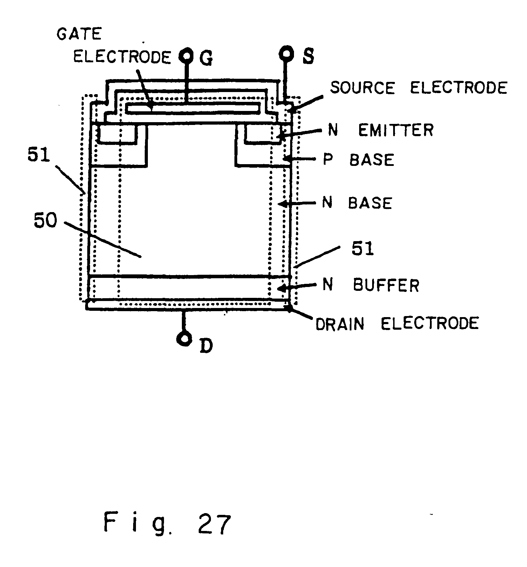

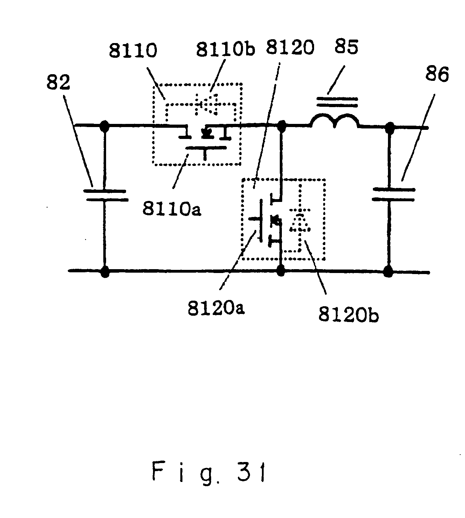

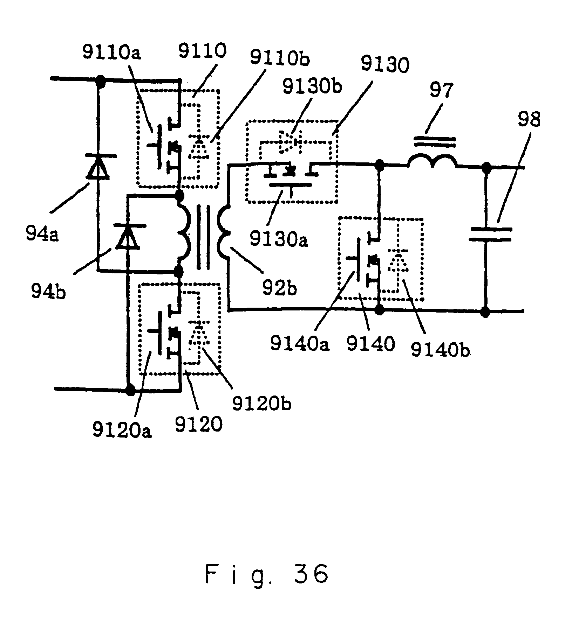

FIG. 27 shows (sectional view) an example of an embodiment of the present invention, shows an example of the sectional structure of the semiconductor switch shown in FIG. 31, shows an example of the internal structure of the semiconductor switch shown in FIG. 36, and shows an example of the structure of the unipolar transistor shown in FIG. 41.

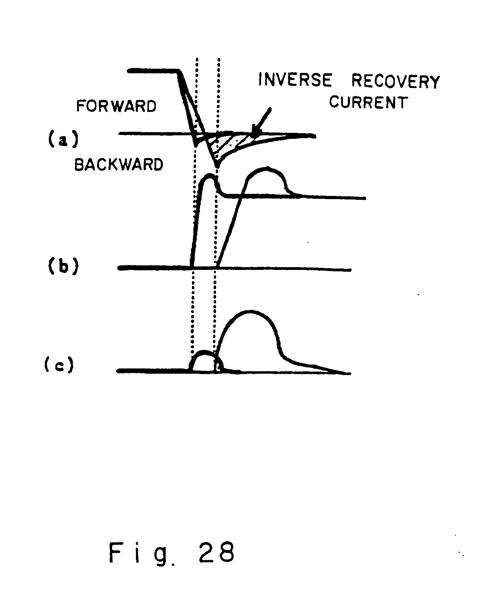

FIG. 28 shows the operation according to an embodiment of the present invention, and shows the waveform for explanation of the parasitic diode characteristic of the MOSFET.

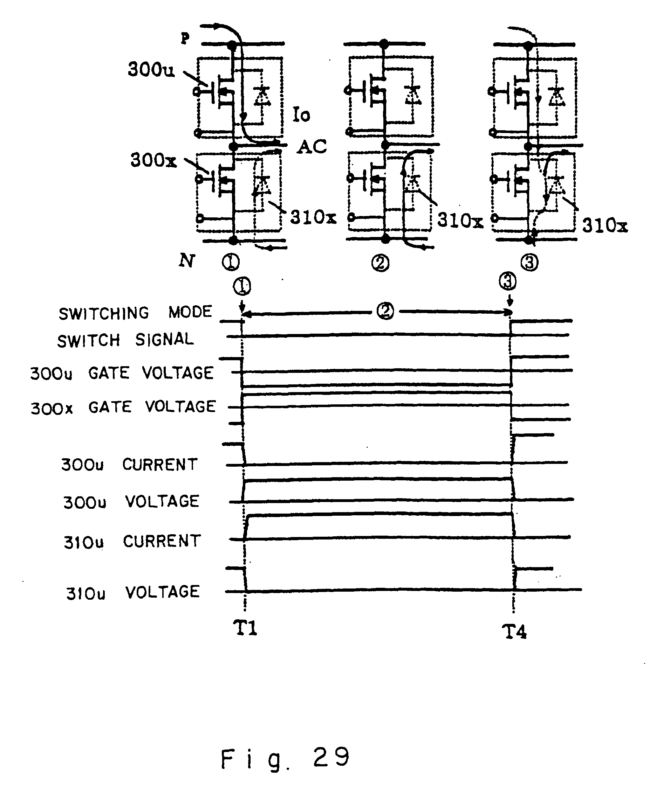

FIG. 29 shows the parasitic diode characteristic of the MOSFET according to the present invention; shows the waveform for explanation of the effect of the present invention, and shows the characteristic for explanation of the operation shown in FIG. 41.

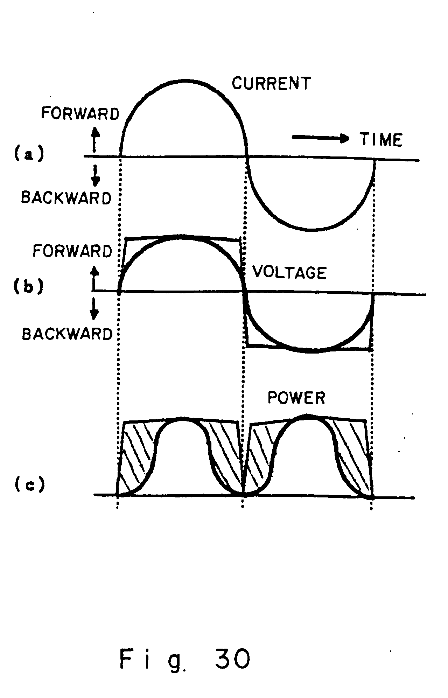

FIG. 30 shows the effect of the present invention.
FIG. 31 shows the circuit configuration according to an embodiment of the present invention.

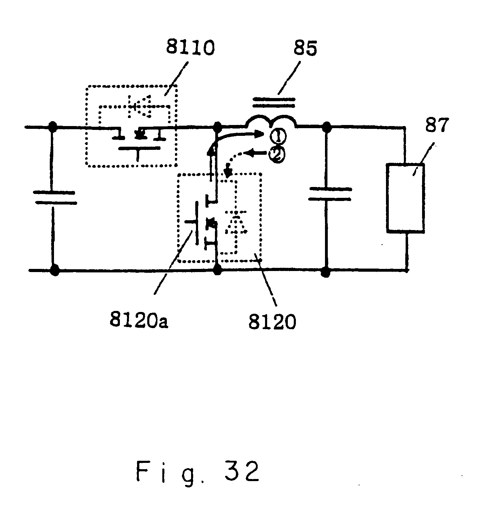

FIG. 32 is an explanatory view of another operation shown in FIG. 31.

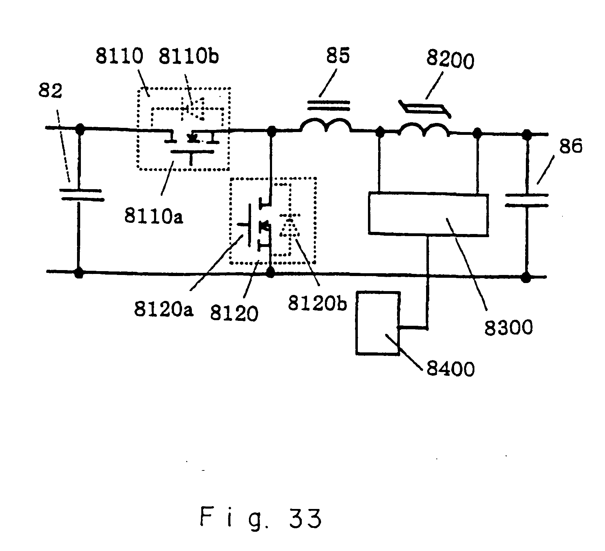

FIG. 33 shows the circuit configuration according to an embodiment of the present invention.

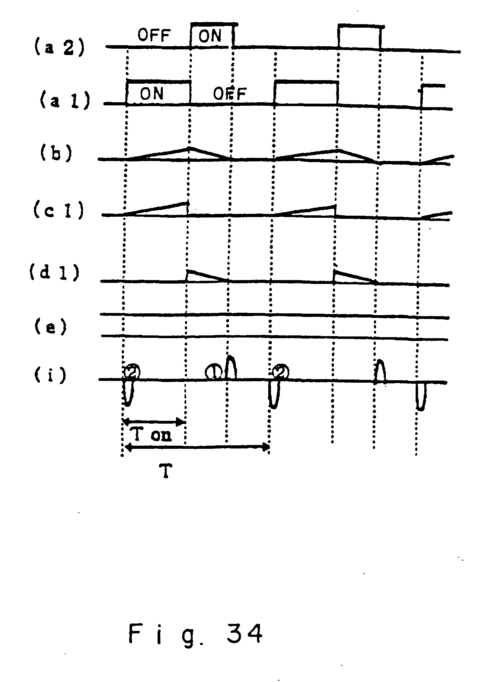

FIG. 34 is another view for explanation of the operation shown in FIG. 33.

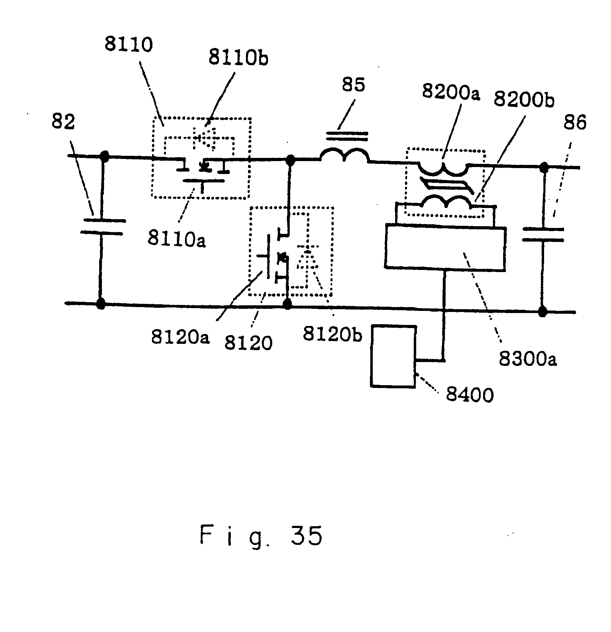

FIG. 35 shows the circuit configuration according to an embodiment of the present invention.
FIG. 36 shows the circuit configuration of the DC-DC converter according to an embodiment of the present invention.

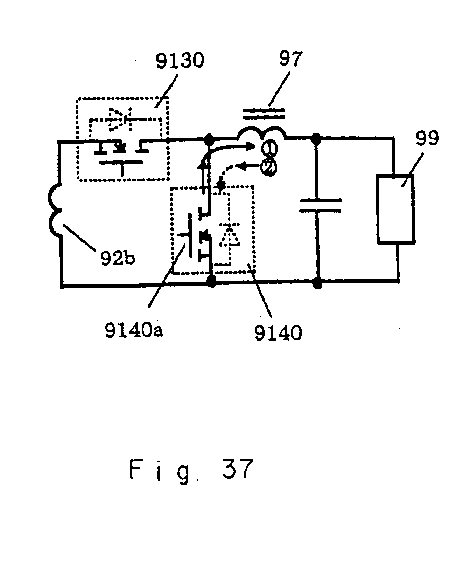

FIG. 37 is a circuit view showing the operation shown in FIG. 36.

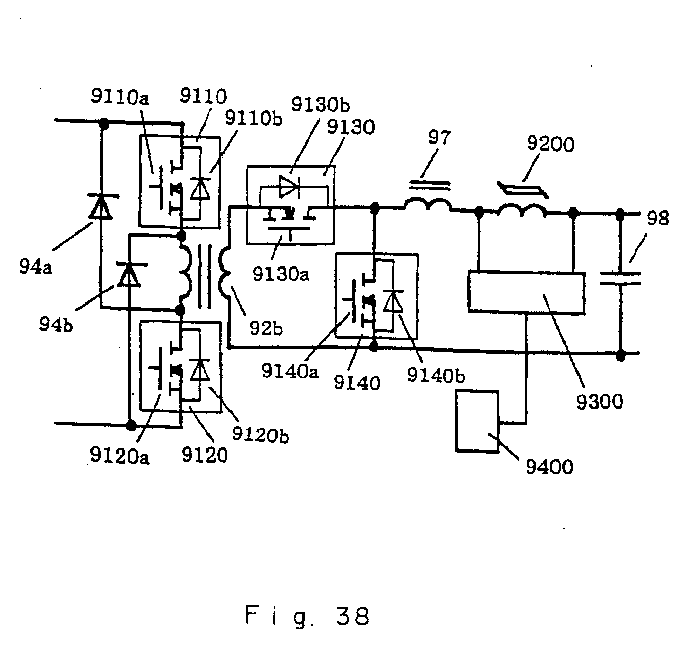

FIG. 38 shows the circuit configuration of the DC-DC converter according to an embodiment of the present invention.

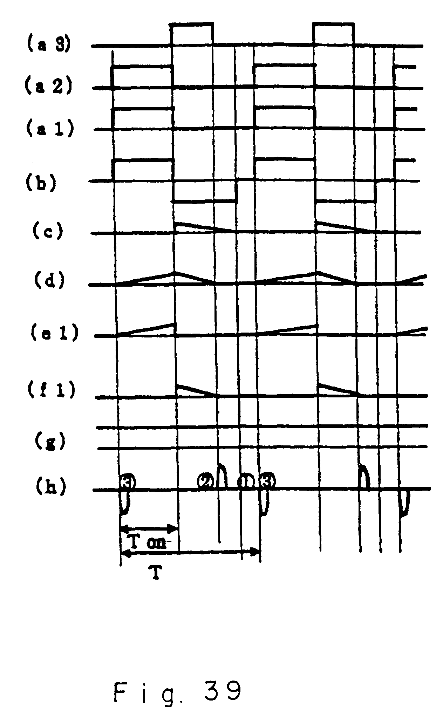

FIG. 39 shows the waveform for explanation of the operation shown in FIG. 38.

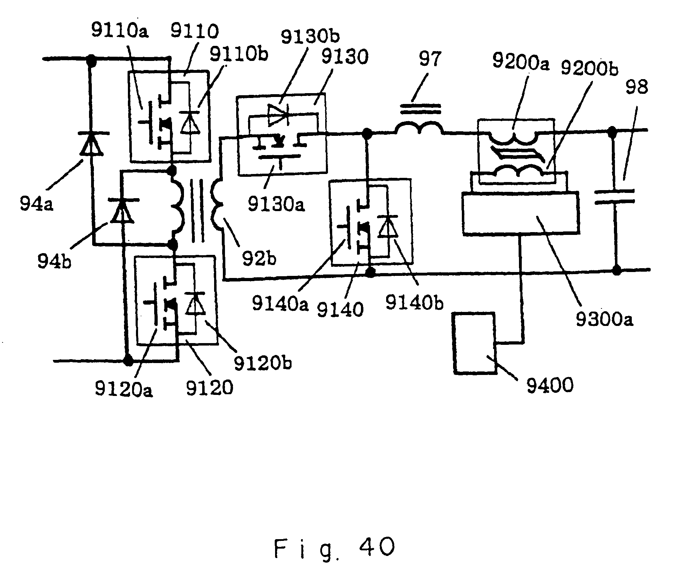

FIG. 40 shows the circuit configuration of the DC-DC converter according to an embodiment of the present invention.
FIG. 41 shows the circuit configuration of the semiconductor switch circuit according to an embodiment of the present invention.

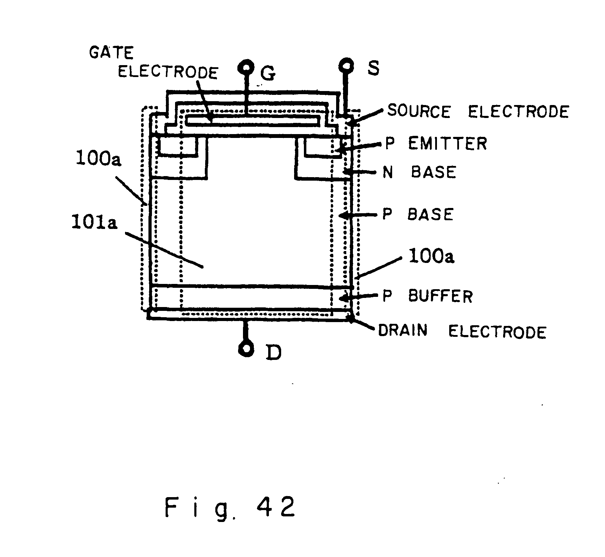

FIG. 42 shows an example of the structure of the unipolar transistor shown in FIG. 41.

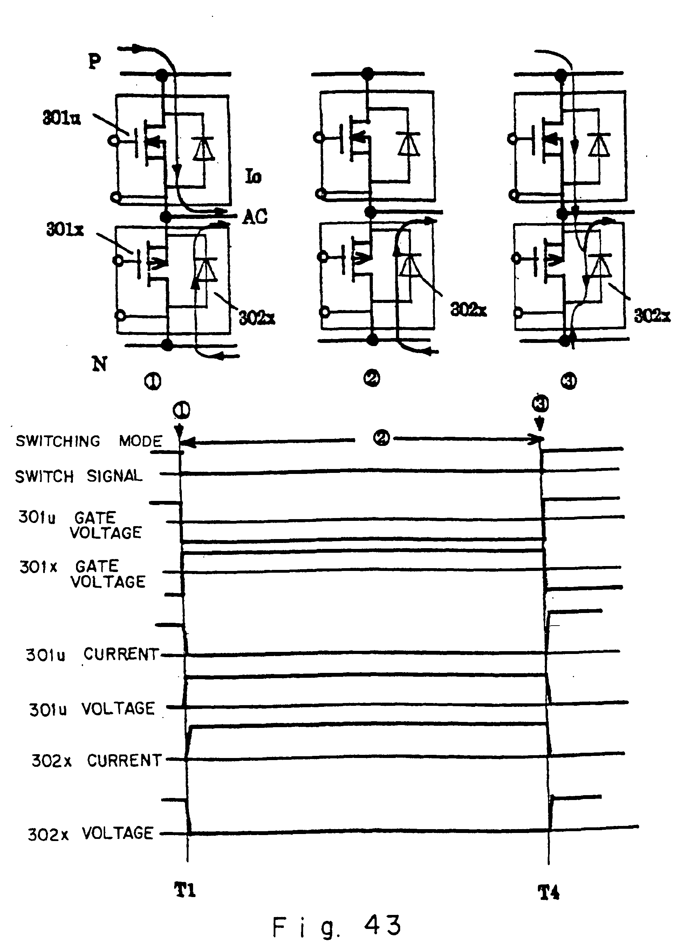

FIG. 43 is an explanatory view of the operation shown in FIG. 41.

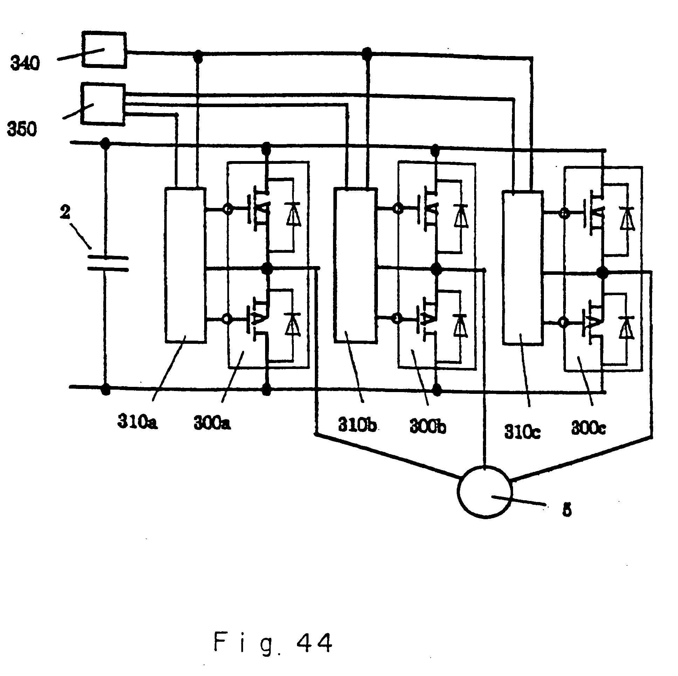

FIG. 44 shows the circuit configuration of the inverter device according to an embodiment of the present invention.

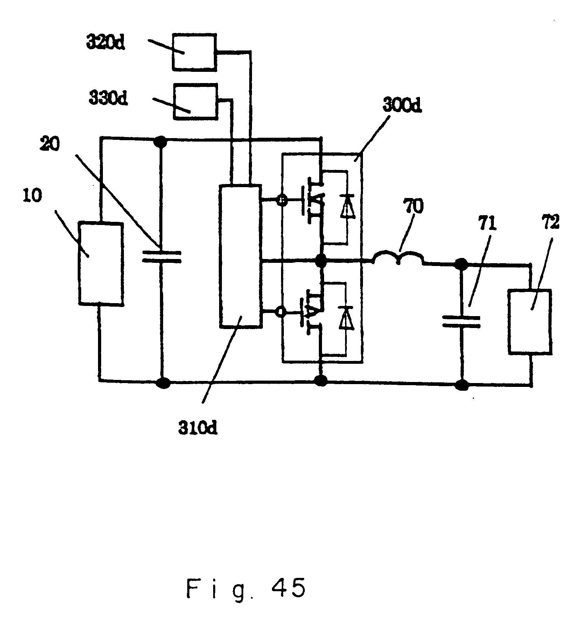

FIG. 45 shows the circuit configuration of the chopper device according to an embodiment of the present invention.

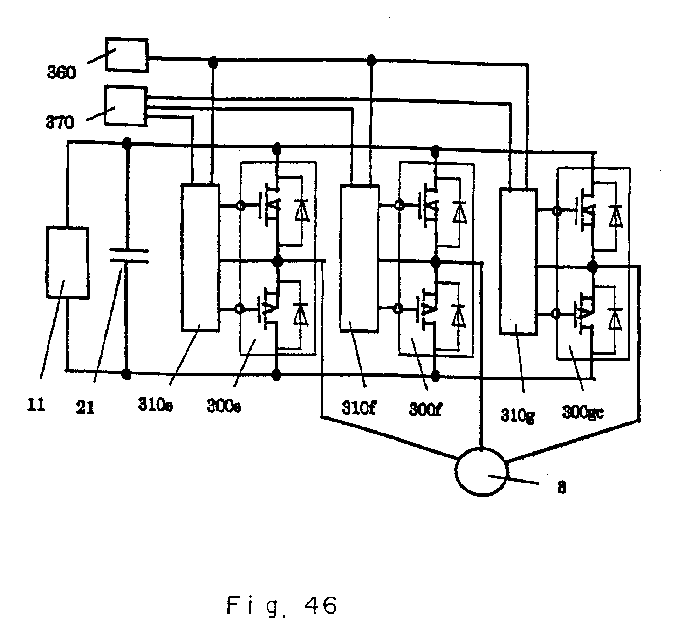

FIG. 46 shows the circuit configuration of the rectifier according to an embodiment of the present invention.

### Best Mode for Carrying Out the Invention

FIG. 26 shows an embodiment of the present invention, and shows the voltage-current characteristic in a forward current and a backward current indicating the device current and the voltage characteristic during the gate-on of the MOSFET which is a unipolar device. 'If' refers to an operation range (represented by a current value) when it is forward, and 'Ir' refers to an operation range when it is backward. The rise voltage Vo of a parasitic diode is set equal to or higher than the voltage Vt generated in the MOSFET, that is, the ON voltage of the MOSFET at the maximum current.

FIG. 27 shows an example of the structure of the MOSFET for realizing the characteristic of the present invention having the same structure as the conventional MOSFET shown in FIG. 4. A common component in FIGS. 4 and 27 is assigned the same reference numeral.

That is, in FIG. 27, reference numeral 51 denotes the parasitic diode unit in a MOSFET unit 52, and reference numeral 50 denotes a MOSFET unit. The operation frequency of the parasitic diode 51 has almost the same frequency function as the MOSFET unit 52.

Normally, the limit of the operation frequency of a diode depends on the inverse recovery characteristic of a diode.

FIG. 28 shows a waveform of an operation during diode-off. In FIG. 28, (a) shows the current waveform of a diode, (b) shows the voltage waveform of a diode, and (c) shows the loss waveform generated in a diode in the off state. In the waveform of (a) shown in FIG. 28, the current of the shadowed portion is an inverse recovery current during diode-off. The waveform of a loss generated during diode-off is obtained as a product of the current shown in (a) and the voltage shown in (b) in FIG. 28. The switching loss of the diode is computed by multiplying the integral value of the loss waveform shown in (c) in FIG. 28 by the switching frequency. In FIG. 28, the bold line indicates the characteristic of the parasitic diode of the conventional MOSFET.

That is, the parasitic diode 51 shown in FIG. 27 has an inverse recovery current of the value of the switching loss for the operation at the operation frequency of the MOSFET. Therefore, as shown by the thin line in FIG. 28, the inverse recovery current is conspicuously reduced by operating the parasitic diode at a higher speed, thereby considerably reducing the loss generated by the current.

The high-speed (high-frequency) operation of the diode unit of the MOSFET according to the present invention can be realized in the same method as the high-frequency operation of the diode unit or simply the diode device of the conventional MOSFET. Although the detailed description is omitted in this example, the method can be followed by, for example, introducing the lifetime killer to the drain area by the dispersion of a heavy metal such as platinum, the irradiation of an electronic beam, etc.

FIG. 24 also shows the switching operation of the inverter using the unipolar transistor shown in FIGS. 26 and 27 in comparison with FIG. 23. The operation of the device according to the present invention is the same as that of the unipolar device having no storage time in the forward and backward directions.

Described below are the operations in the backward current. In FIG. 26, when the current Ir flows backward, the parasitic diode, a small amount of current (indicated by Io in FIG. 26) flows through the parasitic diode. Since the parasitic diode is a bipolar diode, even the small amount of current generates an accumulation carrier. However, an inverse recovery current as large as that of the conventional technology does not flow because the parasitic diode unit of the device of the present invention is operated at a high speed.

FIG. 31 shows the configuration of the circuit according to an embodiment of the present invention.

In FIG. 31, the component also shown in FIGS. 11, 13, and 19 is assigned the same reference numeral.

In FIG. 31, reference numerals 8110 and 8120 denote bi-directional current unipolar type semiconductor switch including unipolar transistors 8110a and 8120a, and diodes 8110b and 8120b parasitic to the unipolar transistor.

In the circuit configuration shown in FIG. 31, the characteristic of the semiconductor switch is a bi-directional unipolar characteristic in the circuit configuration of the bi-directional chopper shown in FIG. 19, and a synchronous rectifying operation is performed.

In the chopper circuit shown in FIG. 31, when the unipolar transistor 8120a is in the gate-on state and the current smoothing reactor current is discontinued, the current flows backward from the DC power 87 as shown by 2 in FIG. 32. 1 shows the current direction when the current continuously flows. Therefore, if the current discontinuation occurs in the synchronous rectification system, it is necessary to turn off the gate of the unipolar transistor 8120a.

FIG. 33 shows the circuit configuration of an embodiment of the present invention in the above mentioned case.

In FIG. 33, a component also appearing in FIG. 31 is assigned the same reference numeral. In FIG. 33, the control circuit includes a saturable reactor 8200, a current discontinuation detection circuit 8300 of the current smoothing reactor, and a control circuit 8400 including the gate drive circuit of the semiconductor switches 8110 and 8120.

In FIG. 33, the controlling operation performed when the current smoothing reactor current continuously flows is the same as the operation shown in FIG. 14. Therefore, the detailed explanation is omitted here.

FIG. 34 shows the operation when the current of the current smoothing reactor is discontinued. Since the current of the current smoothing reactor is to be inverted at time 1, a voltage is generated in the saturable reactor 8200 in the direction as shown in FIG. 34. The generation of a voltage is detected by the current discontinuation detection circuit 8300, and the unipolar transistor 8120a for synchronous rectification is set in the gate-off state. Since the unipolar transistors 8110a and 8120a are in the gate-off state, no inverse current flows from the direct current power 87.

Since the unipolar transistor 8110a is turned on again at time 2, the current starts flowing through the current smoothing reactor, and the voltage having the polarity in inverse direction to time 1 is generated.

FIG. 35 shows the circuit configuration according to an embodiment of the present invention.

In FIG. 35, the component also shown in FIG. 33 is assigned the same reference numeral. The difference from the configuration shown in FIG. 33 is that the saturable reactor 8200 shown in FIG. 33 is replaced with a current smoothing reactor 8200a having a secondary coil 8200b. Using the voltage appearing in the secondary coil, the current discontinuation detection circuit 8300 detects the discontinuation of current of the current smoothing reactor. FIG. 35 is different from FIG. 34 only in that the saturable reactor voltage shown in FIG. 34 is detected from the secondary coil in FIG. 35. Therefore, the description of the operation shown in FIG. 35 is omitted here.

FIG. 36 shows the circuit configuration of the DC-DC converter according to another embodiment of the present invention, and a component also shown in the conventional circuits shown in FIGS. 15, 17, and 20 are assigned the same reference numeral.

That is, the circuit shown in FIG. 36 includes a first semiconductor switch 9110, a second semiconductor switch 9120, a third semiconductor switch 9130, a fourth semiconductor switch 9140, the return current diode 94a is a first diode, and the return current diode 94b is a second diode.

Each of the first through fourth semiconductor switches is a unipolar operation type semiconductor switch having a bi-directional current. Each semiconductor switch comprises unipolar transistors 9110a, 9120a, 9130a, and 9140a, and parasitic diodes 9110b, 9120b, 9130b, and 9140b of the respective unipolar transistors.

The characteristics of the semiconductor switches 9110, 9120, 9130, and 9140 are the same as those shown in FIG. 26.

That is, in comparison with the circuit configuration of the bi-directional operation type DC-DC converter shown in FIG. 20, the circuit configuration of the DC-DC converter shown in FIG. 36 is designed to allow the semiconductor switches 9110, 9120, 9130, and 9140 to perform the operation of a bi-directional unipolar and a synchronously rectifying operation.

Since FIG. 36 is the same as FIG. 18 so far as the current of the current smoothing reactor continuously flows, the explanation is omitted here.

If the current of the current smoothing reactor 97 is discontinued when the unipolar transistor 9140a is in the gate-on state, the current flows backward from the direct current power 99 as shown by 2 shown in FIG. 37 on the part of the secondary coil 92b shown in FIG. 36. The 1 shown in FIG. 37 indicates the direction of the current when the current of the current smoothing reactor 97 continues. Therefore, in the above mentioned synchronous rectification system, when the current is discontinued in the current smoothing reactor 97 of the DC-DC converter, it is necessary to turn off the gate of the unipolar transistor 9140a.

FIG. 38 shows the circuit configuration of the DC-DC converter according to another embodiment of the present invention, shows the circuit configuration of the DC-DC converter capable of turning off the gate of the unipolar transistor 9140a when the current is discontinued as described above, and a component also used in the circuit shown in FIG. 36 is assigned the same reference numeral.

That is, in FIG. 38, the circuit comprises the current smoothing reactor 97 is formed as a DC reactor, a saturable reactor 9200, a current discontinuation detection circuit 9300 of the DC reactor, a control circuit 9400 including the respective gate drive circuits of the semiconductor switches 9110, 9120, 9130, and 9140.

In FIG. 38, since the operation performed when the voltage of the current smoothing reactor 97 continues is the same as the operation shown in FIG. 18, the detailed explanation is omitted here.

FIG. 39 shows the waveform of the operation performed when the current of the current smoothing reactor 97 is discontinued in the DC-DC converter shown in FIG. 38.

That is, since the current of the current smoothing reactor 97 is to be inverted at time 2 shown in FIG. 39, a voltage is generated in the saturable reactor 9200 in the direction indicated by (h). The generation of a voltage is detected by the current discontinuation detection circuit 9300, and the unipolar transistor 9140a in a synchronous rectifying operation is set in the gate-off state. Since the unipolar transistors 9130a and 9140a are in the gate-off state, no inverse current flows from the direct current power 99.

Since the semiconductor switches 9110a, 9120a, and 9130a enter the gate-on state again at time 3 shown in FIG. 39, a current starts flowing through the saturable reactor 9200, and the voltage having the polarity in inverse direction to time 2 is generated.

FIG. 40 shows the circuit configuration of the PC-PC converter according to another embodiment of the present invention, and a component also used in the circuit shown in FIG. 38 is assigned the same reference numeral.

That is, the circuit configuration of the DC-DC converter shown in FIG. 40 is different from the circuit shown in FIG. 38 in that the saturable reactor 9200 is replaced with the saturable reactor having a primary coil 9200a and a secondary coil 9200b, and the discontinuation of the current of the current smoothing reactor 97 can be detected by a current discontinuation detection circuit 9300a using the voltage appearing in the secondary coil 9200b. Therefore, the operation of the circuit shown in FIG. 40 is the same as the operation shown in FIG. 38 other than that the voltage of the current smoothing reactor is detected through the secondary coil. Therefore, the explanation of the operation of the DC-DC converter is omitted here.

FIG. 41 shows the circuit configuration of the semiconductor switch according to the embodiment of the present invention, and the circuit configuration corresponds to that of the conventional technology shown in FIG. 8.

That is, in FIG. 41, the circuit comprises upper and lower arms 300 of the semiconductor power converter with a bridge connection configuration, an upper arm 300u, a lower arm 300x, an N channel MOSFET 301u, a P channel MOSFET 301x, a gate drive circuit 310 of the N channel MOSFET 301u and the P channel MOSFET 301x, a gate power circuit 311, a transformer 312, a gate control circuit 313, a transformer 314, a gate drive circuit 315, a gate drive power 320, and a switching control circuit 330.

FIG. 42 shows an example of the basic structure of the P channel MOSFET according to the present invention. In the structure, a parasitic diode unit 100a is stored by a MOSFET unit 101a. Like the parasitic diode unit 50 shown in FIG. 27, the operation frequency of the parasitic diode unit 100a is almost the same as that of the MOSFET unit 101a.

The operation at a higher speed (higher frequency) of the parasitic diodes 51 and 100a of the MOSFET is realized in the same method as the operation of the conventional diode device at a higher frequency. In this example, the detailed explanation of the method is omitted, but the lifetime is controlled by, for example, doping platinum, etc. which is a lifetime killer, irradiating an electronic beam, etc.

FIG. 43 shows the switching operation of the semiconductor switch circuit shown in FIG. 41, and corresponds to the explanatory view of the conventional circuit shown in FIG. 23.

That is, as shown in FIG. 26, in the MOSFET according to the present invention, the operation of the unipolar device having no accumulation carrier time is performed in both forward and backward currents. Therefore, a switching operation is performed without considering the above mentioned dead time.

Furthermore, in the backward current of the MOSFET according to the present invention, that is, when the current Ir flows backward as shown in FIG. 26, the current slightly flows (Io shown in FIG. 26) through the parasitic diode of the MOSFET. Since the parasitic diode is bipolar, the slight current can generate accumulated carrier. However, since the parasitic diode is operated at a higher speed in the MOSFET according to the present invention, such a large backward recovery current as in the conventional circuit does not flow.

FIG. 44 shows another embodiment of the present invention, that is, the circuit configuration in which the semiconductor switch circuit shown in FIG. 41 is applied to the three-phase inverter device. A component also used in the conventional circuit shown in FIG. 5 is assigned the same reference numeral.

That is, in FIG. 44, upper and lower arms 300a, 300b, and 300c correspond to the upper and lower arms 300, gate drive circuits 310a, 310b, and 310c correspond to the gate drive circuit 310 shown in FIG. 41, a gate drive power 340 corresponds to the gate drive power 320 shown in FIG. 41, and an inverter control circuit 350 corresponds to the switching control circuit 330 shown in FIG. 41.

Since the controlling operations of the three-phase inverter device and each semiconductor switch circuit forming each of the upper and lower arms shown in FIG. 44 are well known, the detailed explanation is omitted here.

FIG. 45 shows another embodiment of the present invention in which the semiconductor switch circuit shown in FIG. 41 is applied to a chopper device.

In FIG. 45, the circuit comprises a switch arm 300d corresponding to the upper and lower arms 300 shown in FIG. 41, a gate drive circuit 310d corresponding to the gate drive circuit 310 shown in FIG. 41, a gate drive power 320d corresponds to the gate drive power 320 shown in FIG. 41, a chopper control circuit 330d corresponds to the switching control circuit 330, a DC power 10 of the chopper device, a smoothing capacitor 20, a reactor 70, a smoothing capacitor 71, and a load 72 of the chopper device.

Since the controlling operations of the semiconductor switch circuit forming the chopper device and the switch arms are well know, the detailed explanation is omitted here.

FIG. 46 shows another embodiment of the present invention, that is, the circuit configuration in which the semiconductor switch circuit shown in FIG. 41 is applied to a rectifier.

In FIG. 46, the circuit comprises upper and lower arms 300e, 300f, and 300g corresponding to the upper and lower arms 300 shown in FIG. 41, gate drive circuits 310e, 310f, and 310g corresponding to the gate drive circuit 310 shown in FIG. 41, a gate drive power 360 corresponding to the gate drive power 320 shown in FIG. 41, a converter control circuit 370 corresponding to the switching control circuit 330 shown in FIG. 41, an AC power 8, a DC load 11, and a smoothing capacitor 21.

Since the controlling operations of each semiconductor switch circuit forming the rectifier and each of the upper and lower arms shown in FIG. 46 are well known, the detailed explanation is omitted here.

### Industrial Applicability

According to the present invention, the unipolar characteristic is effective both forward and backward, thereby considerably reducing the device generated loss.

FIG. 28 shows the waveform for explanation of the effect. (a) shows a device current waveform of a bi-directional sine-wave current, (b) shows a device voltage waveform with the thin line indicating the IGBT and the bold line indicating the MOSFET according to the present invention, and (c) shows a loss generated in the device with a thin line indicating the IGBT and the bold line indicating the MOSFET according to the present invention. In FIG. 28, (c) shows the shadowed portion which is a loss portion to be reduced by the present invention.

As clearly shown in FIG. 28, the MOSFET as a unipolar transistor according to the present invention can considerably reduce the loss generated in the device.

FIG. 30 shows the effect. In FIG. 30, (a) shows a device current waveform of a bi-directional sine-wave current, (b) shows a device voltage waveform with the thin line indicating the IGBT (bipolar device) and the bold line indicating the MOSFET (unipolar device) according to the present invention, and (c) shows a loss generated in the device with a thin line indicating the IGBT (bipolar device) and the bold line indicating the MOSFET (unipolar device) according to the present invention. The (c) shows the shadowed portion which is a loss portion to be reduced by the present invention.

As shown in FIG. 30, using the bi-directional unipolar device according to the present invention, a loss generated in the device can be considerable reduced. If it is applied to an inverter, the characteristic indicated by the solid line shown in FIG. 22 can be realized, thereby enhancing the efficiency when a load is small.

Furthermore, according to the present invention, the rise voltage of a parasitic diode is enhanced much more than the conventional technology so that the operation can be performed at almost the same switching frequency as the MOSFET. Therefore, the switching frequency of the inverter can be largely raised, thereby realizing a smaller, lighter, and less expensive filter circuit mounted in the input/output circuit of the inverter.

As described above, since a unipolar operation is performed in bi-directional currents according to the present invention, the dead time by a storage time is practically zero, thereby increasing the output voltage of an inverter. Furthermore, the voltage waveform can be greatly improved, and the control ability of an inverter can also be greatly improved.

That is, according to the present invention, the circuit configuration of the chopper is designed using a switching device in a bi-directional unipolar operation with the rise voltage of the parasitic diode of the unipolar transistor enhanced, and in an operation at a higher frequency, thereby obtaining the following effect.
(1) Since the bi-directional step-down and step-up operations can be realized in an incorporated format, a smaller, lighter, and less-expensive device can be realized.
(2) Although the current smoothing reactor current is discontinued, a synchronous rectifying operation can be performed, thereby realizing an efficient operation.
(3) Since the switching device performs a unipolar operation both forward and backward, the loss of the switch device can be reduced, and an efficient chopper can be realized.

Since the semiconductor switch circuit according to the present invention has a unipolar characteristic in both forward current and backward current, a loss generated during the switching operation can be considerably reduced.

FIG. 30 shows the above mentioned effect. (a) shows a current waveform in a bi-directional sine wave current, (b) shows a voltage waveform with a thin line indicating the IGBT of a conventional circuit, and a bold line indicating the MOSFET forming the semiconductor switch circuit according to the present invention, and (c) shows a generated loss with a thin line indicating the IGBT, and a bold line indicating the MOSFET. That is, the shadowed portion shown in (c) is a loss portion which can be improved according to the present invention. If the unipolar characteristic is realized according to the present invention in bi-directional currents, a loss generated in a device is considerably reduced.

According to the present invention, the rise voltage of a parasitic diode of the MOSFET can be largely enhanced much more than the conventional device with almost the same switching frequency as the MOSFET, thereby greatly enhancing the switching frequency, and realizing the characteristic shown in FIG. 22.

Furthermore, a semiconductor switch circuit with a complementary connection realizes the same source potential of each MOSFET of the upper and lower arms with the bridge circuit. Therefore, the gate drive power and the gate drive circuit can be shared. As a result, when the semiconductor switch circuit according to the present invention is applied to the semiconductor power conversion device such as an inverter device, a chopper device, etc., a smaller, lighter, and less expensive product can be designed.

## Claims

1. A unipolar transistor having a parasitic diode opposite parallel in direction to the unipolar transistor, **characterized in that**
a rise voltage of the parasitic diode is set equal to or higher than an ON voltage appearing when a predetermined current flows with the unipolar transistor set in an ON state.

2. The unipolar transistor according to claim 1, **characterized in that**
an operable switching frequency of the parasitic diode is set almost the same as a switching frequency of the unipolar transistor.

3. The unipolar transistor according to claim 1 or 2, **characterized in that** the unipolar transistor is a MOSFET.

4. The unipolar transistor according to any of claims 1 through 3, **characterized in that**
said predetermined current of the unipolar transistor is set to a maximum absolute rating of the transistor.

5. An inverter in which a unipolar transistor, having a rise voltage of a parasitic diode included in antiparallel to the unipolar transistor set equal to or higher than an ON voltage appearing when a specified current flows in an ON state of the unipolar transistor, is configured as a primary switching device.

6. The inverter according to claim 5, **characterized in that**
said unipolar transistor is a MOSFET.

7. The inverter according to claim 5 or 6, **characterized in that**
said specified current is a maximum inverter output current.

8. The inverter according to claim 5 or 6, **characterized in that**
said specified current is an absolute maximum rating of a MOSFET.

9. A DC-DC converter in which one terminal of a first semiconductor switch is connected to one terminal of a first direct current power, one terminal of a second semiconductor switch and one terminal of a current smoothing reactor are connected to another terminal of the first semiconductor switch, one terminal of a second direct current power is connected to another terminal of the current smoothing reactor, and another terminal of the first direct current power, another terminal of the second semiconductor switch, and another terminal of the second direct current power are connected to each other, **characterized in that**:
said first and second semiconductor switches are unipolar transistors each having a parasitic diode; and
said rise voltage of the parasitic diode is set equal to or higher than an ON voltage appearing when a specified current flows through the unipolar transistor.

10. The DC-DC converter according to claim 9, in that
said parasitic diode is assigned a high frequency so that the parasitic diode can be operated at an operation switching frequency of each unipolar transistor.

11. The DC-DC converter according to claim 9 or 10, **characterized in that**
said unipolar transistor is used as a MOSFET.

12. The DC-DC converter according to any of claims 9 through 11, **characterized in that**
a current of each of the first and second semiconductor switches is allowed to flow through the unipolar transistor.

13. The DC-DC converter according to any of claims 9 through 12, **characterized in that**
switching operations of the first and second semiconductor switches allow power conversion to be performed in both directions between the first direct current power and the second direct current power.

14. The DC-DC converter according to any of claims 9 through 13, **characterized in that**
said current smoothing reactor is formed by a serial circuit of a DC reactor and a saturable reactor, and a current discontinuation of the current reactor can be detected by a voltage appearing in the saturable reactor when the current of the current smoothing reactor is inverted.

15. The DC-DC converter according to any of claims 9 through 14, **characterized in that**
said current smoothing reactor is formed by a serial circuit of a primary coil of a DC reactor and a saturable reactor, and a current discontinuation of the current smoothing reactor can be detected by a voltage appearing in a secondary coil of the saturable reactor when a current of the current smoothing reactor is inverted.

16. A DC-DC converter in which:
a first serial circuit formed by serially connecting a first direct current power with a first semiconductor switch and a first diode is connected parallel to a second serial circuit formed by serially connecting a second diode with a second semiconductor switch;
both terminals of a primary coil of a transformer are connected between the intermediate connection point of the first serial circuit and the intermediate connection point of the second serial circuit;
one terminal of a third semiconductor switch is connected to one terminal of a secondary coil of the transformer;
one terminal of a fourth semiconductor switch and one terminal of a current smoothing reactor are connected to another terminal of the third semiconductor switch;
one terminal of a second direct current power is connected to another terminal of the current smoothing reactor; and
another terminal of the secondary coil of the transformer, another terminal of the fourth semiconductor switch, and another terminal of the second direct current power are connected to one another, **characterized in that**:
each of the first through the fourth semiconductor switches is a unipolar transistor having a parasitic diode; and
a rise voltage of each parasitic diode is set equal to or higher than an ON voltage appearing when a specified current flows through each unipolar transistor.

17. The DC-DC converter according to claim 16, **characterized in that**
each parasitic diode is operated at a higher frequency so that each parasitic diode can be operated at an operation switching frequency of each unipolar transistor.

18. The DC-DC converter according to claim 16 or 17, **characterized in that**
said unipolar transistor is a MOSFET.

19. The DC-DC converter according to any of claims 16 through 18, **characterized in that**
said current of each of the first through fourth semiconductor switches flows through the unipolar transistor.

20. The DC-DC converter according to any of 16 through 19, **characterized in that**
bi-directional power conversion is performed between the first direct current power and second direct current power by each switching operation of each of said first through fourth semiconductor switches.

21. The DC-DC converter according to any of claims 16 through 20, **characterized in that**
said current smoothing reactor is formed by a serial circuit of a DC reactor and a saturable reactor; and
a current discontinuation of the current smoothing reactor can be detected by a voltage appearing in the saturable reactor when the current of the current smoothing reactor is inverted.

22. The DC-DC converter according to any of claims 16 through 20, **characterized in that**
said current smoothing reactor is formed by a serially connected circuit of primary coils of a DC reactor and a saturable reactor; and
a current discontinuation of the current smoothing reactor can be detected by a voltage appearing in a secondary coil of the saturable reactor when the current of the current smoothing reactor is inverted.

23. A semiconductor switch circuit formed by a complementary connection of a unipolar transistor having a parasitic diode, **characterized in that**
a rise voltage of each parasitic diode is set equal to or higher than an ON voltage appearing when a specified current flows in an ON state of the unipolar transistor.

24. A semiconductor switch circuit according to claim 23, **characterized in that**
one of the unipolar transistors is an N channel MOSFET, and another is a P channel MOSFET.

25. The semiconductor switch circuit according to claim 23 or 24, **characterized in that**
said specified current is a maximum current through the semiconductor switch circuit.

26. The semiconductor switch circuit according to claim 24, **characterized in that**
said specified current is a maximum absolute rating of the MOSFET.

27. The semiconductor switch circuit according to any of claims 23 through 26, **characterized in that**
said semiconductor switch circuit is formed by upper and lower arms of an inverter device with a bridge connection configuration.

28. The semiconductor switch circuit according to any of claims 23 through 26, **characterized in that**
said semiconductor switch circuit is the switch arm of a chopper device.

29. The semiconductor switch circuit according to any of claims 23 through 26, **characterized in that**
said semiconductor switch circuit is formed by upper and lower arms of the rectifier with a bridge connection configuration.
